(19) Europäisches Patentamt
European Patent Office
Office européen des brevets

(11) **EP 3 564 800 A1**

(12) **EUROPEAN PATENT APPLICATION**
published in accordance with Art. 153(4) EPC

(43) Date of publication:
06.11.2019 Bulletin 2019/45

(51) Int Cl.:
*G06F 3/041* (2006.01)　　　*G06F 3/044* (2006.01)
*H05K 1/02* (2006.01)

(21) Application number: 17889496.0

(22) Date of filing: 25.12.2017

(86) International application number:
PCT/JP2017/046438

(87) International publication number:
WO 2018/123974 (05.07.2018 Gazette 2018/27)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD TN

(30) Priority: 28.12.2016 JP 2016256468

(71) Applicant: Fujikura Ltd.
Tokyo 135-8512 (JP)

(72) Inventor: OGURA, Shingo
Sakura-shi
Chiba 285-8550 (JP)

(74) Representative: Ter Meer Steinmeister & Partner
Patentanwälte mbB
Artur-Ladebeck-Strasse 51
33617 Bielefeld (DE)

(54) **WIRING BODY, WIRING BOARD AND TOUCH SENSOR**

(57)　A wiring body 40 includes: a second resin portion 70; a first conductor portion 60 provided on one side of the second resin portion and including a first electrode portion 61; and a second conductor portion 80 provided on the other side of the second resin portion and including a second electrode portion 81, the first electrode portion has first thin lines 611 intersecting each other and includes at least one first lattice 612 formed by the first thin lines, the second electrode portion has second thin lines 811 intersecting each other and includes at least one second lattice 812 formed by second thin lines, the first electrode portion and the second electrode portion are disposed to face each other, so that, in a see-through plane view, there exist an overlapping region 41 where the first electrode portion and the second electrode portion partially overlap and a non-overlapping region 42 other than the overlapping region, in a see-through plane view, an area occupied by the first thin lines and the second thin lines per unit area in the overlapping region of the first electrode portion or the second electrode portion is larger than an area occupied by the first thin lines or the second thin lines per unit area in the non-overlapping region, the first conductor portion includes a first dummy electrode portion 63 located on the same plane as the first electrode portion and electrically insulated from the first electrode portion, and the first dummy electrode portion exists in at least one first lattice in the non-overlapping region.

FIG. 9

**Description**

TECHNICAL FIELD

The invention relates to a wiring body, a wiring board, and a touch sensor.

For designated countries that are permitted to be incorporated by reference in the literature, the contents described in Japanese Patent Application No. 2016-256468 filed in Japan on December 28, 2016 are incorporated herein by reference and made a part of the description of this specification.

BACKGROUND ART

There is known a touch panel in which two or more large lattices and a connection portion electrically connecting adjacent large lattices are included, the large lattice is configured by combining two or more small lattices, and one or more medium lattices having a pitch of n times pitch of the small lattices are disposed to constitute a connection portion (refer to, for example, Patent Document 1). In this touch panel, when viewing a stacked two-layered conductive sheet from the top surface, the plurality of small lattices are disposed by combining the connection portions facing each other, and thus, the large lattice and the small lattices constituting the surrounding large lattice cannot be distinguished from each other, so that the visibility of the touch panel is improved.

There is also known a touch panel in which a first conductive portion having a first conductive pattern to which a plurality of first electrodes are connected and a second conductive portion having a second conductive pattern disposed in a direction perpendicular to the arrangement direction of the first conductive patterns and to which a plurality of second electrodes are connected, and the first conductive portion and/or the second conductive portion includes a dummy electrode which is disposed between the first electrode and the second electrode and another dummy electrode which is included in the first conductive portion and is disposed in a portion corresponding to the second electrode (refer to, for example, Patent Document 2). In this touch panel, when viewing the stacked two-layered conductive sheet from the top surface, another dummy electrode allows the light transmittance of the portion corresponding to the first electrode and the light transmittance of the portion corresponding to the second electrode to be uniform, so that the visibility of the touch panel is improved.

CITATION LIST

PATENT DOCUMENT

Patent Document 1; Japanese Patent No. 4820451
Patent Document 2; Japanese Patent No. 5615856

DISCLOSURE OF THE INVENTION

PROBLEM TO BE SOLVED BY THE INVENTION

However, in the related art described in the above-mentioned Patent Document 1, there is a problem that circuit resistance is increased due to a decrease in a conduction path at the connection portion, and thus, sensor sensitivity of the touch panel is lowered.

In addition, in the related art described in Patent Document 2, since another dummy electrode and the second electrode are disposed to face each other, when the finger tip comes into contact with or comes close to the protective layer, another dummy electrode is located between the finger tip and the second electrode, and thus, the line of electric force that is to originally arrive at the finger from the second electrode is allowed to enter the dummy electrode. For this reason, there is a problem that parasitic capacitance is generated between the other dummy electrode and the second electrode, so that the sensor sensitivity of the touch panel may be lowered.

The invention is to provide a wiring body, a wiring board, and a touch sensor that can improve visibility and to improve sensor sensitivity.

MEANS FOR SOLVING PROBLEM

[1] A wiring body according to the invention is a wiring body includes: an insulating portion; a first conductor portion provided on one side of the insulating portion and including a first electrode portion; and a second conductor portion provided on the other side of the insulating portion and including a second electrode portion, in which the first electrode portion has first thin lines intersecting each other and includes at least one first lattice formed by the first thin lines, the second electrode portion has second thin lines intersecting each other and includes at least one second lattice formed by the second thin lines, the first electrode portion and the second electrode portion are disposed to face each other, so that, in a see-through plane view, there exist an overlapping region in which the first electrode portion and the second electrode portion partially overlap and a non-overlapping region other than the overlapping region, in a see-through plane view, an area occupied by the first thin lines and the second thin lines per unit area in the overlapping region of the first electrode portion or the second electrode portion is larger than an area occupied by the first thin lines or the second thin lines per unit area in the non-overlapping region, the first conductor portion includes a first dummy electrode portion located on the same plane as the first electrode portion and electrically insulated from the first electrode portion, and the first dummy electrode portion exists in at least one of the first lattices in the non-overlapping region.

[2] In the above invention, the first conductor portion or the second conductor portion may include a second dummy electrode portion located on the same plane as the first electrode portion or the second electrode portion and electrically insulated from the first electrode portion or the second electrode portion, and, in a see-through plane view, the second dummy electrode portion may exist in at least one of the second lattices in the non-overlapping region.

[3] In the above invention, the first dummy electrode portion may have third thin lines extending in directions intersecting each other, third lattices may be formed by overlapping the first thin line and the second thin line in the overlapping region, fourth lattices may be formed by combining the first thin line and the third thin line in the non-overlapping region, and the fourth lattice may have substantially the same shape as the third lattice.

[4] In the above invention, the first dummy electrode portion may include at least one first disconnection portion formed at an intersection of the third thin lines.

[5] In the above invention, in the first electrode portion, the first thin line protruding into the first lattice may not exist, and the first dummy electrode portion may include second disconnection portions formed at all intersections of the first thin lines and the third thin lines.

[6] In the above invention, the following formula (1) may be satisfied,

$$S_1 \leq L/10 \ldots (1)$$

herein, in the formula (1), $S_1$ is an interval between the first thin line and the third thin line at the second disconnection portion, and L is a length of one side of the fourth lattice.

[7] In the above invention, the following formulas (2) and (3) may be satisfied,

$$(S_2 - S_3) \times 0.5/H \leq 1 \ldots (2)$$

$$S_3 < 50 \ \mu m \ldots (3)$$

herein, in the formulas (2) and (3), $S_2$ is a maximum interval between the first thin line and the third thin line at the second disconnection portion, $S_3$ is a minimum interval between the first thin line and the third thin line at the second disconnection portion, and H is a height of the third thin line.

[8] In the above invention, the non-overlapping region may include a gap region not overlapping both the first electrode portion and the second electrode portion in a see-through plane view, at least one of the first conductor portion and the second conductor portion may include a third dummy electrode portion located on the same plane as the first electrode portion or the second electrode portion and electrically insulated from the first electrode portion or the second electrode portion, and the third dummy electrode portion may exist in the gap region.

[9] In the above invention, the third dummy electrode portion may have fifth thin lines extending in directions intersecting each other and may include at least one fifth lattice formed by the fifth thin line, and the fifth lattice may have substantially the same shape as the third lattice.

[10] In the above invention, the first electrode portion may include: first detection portions having a substantially rhombus shape in a plane view and juxtaposed in an extension direction of the first electrode portion; and a first connection portion connecting the adjacent first detection portions to each other, the second electrode portion may include: second detection portions having a substantially rhombus shape in a plane view and juxtaposed in an extension direction of the second electrode portion; and a second connection portion connecting the adjacent second detection portions with each other, the first connection portion and the second connection portion may be disposed in the overlapping region, and the first detection portion and the second detection portion may be disposed in the non-overlapping region.

[11] A wiring board according to the invention is a wiring board including the above-described wiring body and a supporting body supporting the wiring body.

[12] A touch sensor according to the invention is a touch sensor detecting a touch position of an external conductor, including the above-described wiring board according to the invention, in which the second conductor portion is disposed so as to be interposed between the external conductor and the first conductor portion.

EFFECT OF THE INVENTION

According to the invention, the difference in light shielding ratio between the overlapping region and the non-overlapping region becomes small, it is difficult for the circuit resistance to increase at the connection portion, and it is difficult for the parasitic capacitance to occur between the electrode portion and the dummy electrode portion. For this reason, it is possible to improve visibility and to improve sensor sensitivity.

BRIEF DESCRIPTION OF DRAWINGS

Fig. 1 is a plan view illustrating a touch sensor according to a first embodiment of the invention;

Fig. 2 is an exploded perspective view illustrating the touch sensor;

Fig. 3 is a see-through plan view illustrating a first electrode portion and a second electrode portion according to the first embodiment of the invention;

Fig. 4 is a plan view illustrating a first electrode portion according to the first embodiment of the invention;

Fig. 5 is a cross-sectional view taken along line V-V of Fig. 4;

Fig. 6 is a plan view illustrating a second electrode portion according to the first embodiment of the invention;

Fig. 7 is an enlarged see-through plan view illustrating an overlapping region of the first electrode portion and the second electrode portion according to the first embodiment of the invention;

Fig. 8 is a plan view illustrating a first conductor portion according to the first embodiment of the invention;

Fig. 9 is a partial enlarged view of a portion IX of Fig. 8;

Fig. 10 is a cross-sectional view taken along line X-X of Fig. 9;

Fig. 11 is a plan view illustrating a first electrode portion and a first dummy electrode portion according to the first embodiment of the invention;

Fig. 12 is a plan view illustrating a second conductor portion according to the first embodiment of the invention;

Fig. 13 is a partially enlarged view of a portion XIII of Fig. 12;

Fig. 14 is a see-through plan view illustrating a first conductor portion and a second conductor portion according to Comparative Example;

Fig. 15 is a see-through plan view illustrating the first conductor portion and the second conductor portion according to the first embodiment of the invention;

Fig. 16 is a plan view illustrating a first conductor portion and a first dummy electrode portion according to a second embodiment of the invention;

Fig. 17 is a plan view illustrating a first conductor portion according the second embodiment of the invention;

Fig. 18 is a plan view illustrating a second conductor portion according to the second embodiment of the invention;

Fig. 19 is a see-through plan view illustrating the first conductor portion and the second conductor portion according to the second embodiment of the invention;

Fig. 20 is a plan view illustrating a first conductor portion according to a third embodiment of the invention; and

Fig. 21 is a plan view illustrating a second conductor portion according to the third embodiment of the invention.

BEST MODE(S) FOR CARRYING OUT THE INVENTION

Hereinafter, embodiments of the invention will be described with reference to the drawings.

[First Embodiment]

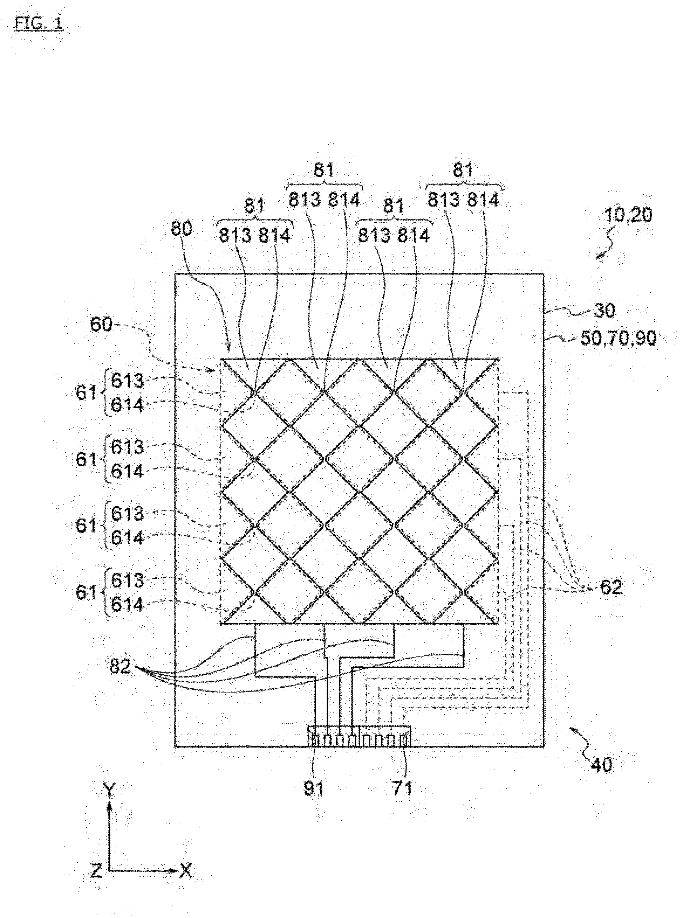

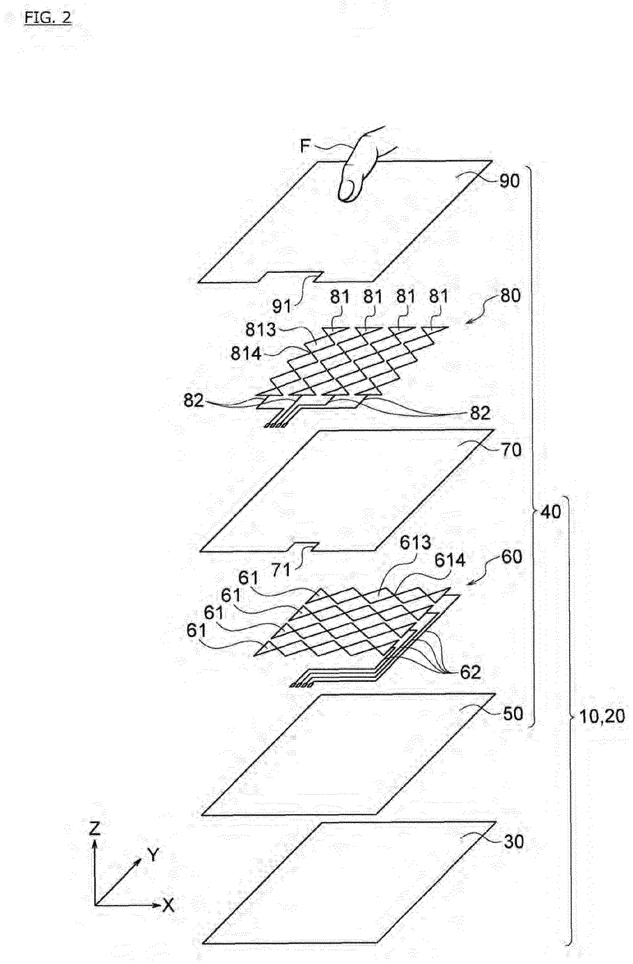

Fig. 1 is a plan view illustrating a touch sensor according to a first embodiment of the invention, and Fig. 2 is an exploded perspective view illustrating the touch sensor. In order to easily understand the touch sensor 10 of the embodiment, in Fig. 1, a first conductor portion 60 is indicated by a solid line.

The touch sensor 10 illustrated in Fig. 1 is a projection-type capacitive touch panel sensor and is used as an input device having a function of detecting a touch position in combination with, for example, a display device (not illustrated) or the like. The display device is not particularly limited, and a liquid crystal display, an organic EL display, an electronic paper, or the like can be used. The touch sensor 10 includes a detection electrode and a driving electrode (a first electrode portion 61 and a second electrode portion 81 which will be described later) which are disposed in the display region of the touch sensor 10 and face each other, and a predetermined voltage is periodically applied from an external circuit (not illustrated) between the two electrodes.

In such a touch sensor 10, for example, when a finger F (external conductor F) of an operator approaches the touch sensor 10, a condenser (electric capacitor) is formed between the external conductor F and the touch sensor 10, an electrical state between the two electrodes is changed. The touch sensor 10 can detect an operation position of the operator on the basis of an electrical change between the two electrodes.

The touch sensor 10 includes a wiring board 20, and as illustrated in Fig. 2, the wiring board 20 includes a supporting body 30 and a wiring body 40. In order to ensure the visibility of the display device, the wiring board 20 of the embodiment is configured so as to have transparency (translucency) as a whole.

The supporting body 30 has a rectangular outer shape and is made of a material having transparency. As a material constituting the supporting body 30, for example, polyethylene terephthalate (PET), polyethylene naphthalate (PEN), a polyimide resin (PI), a polyether imide resin (PEI), polycarbonate (PC), polyether ether ketone (PEEK), a liquid crystal polymer (LCP), a cycloolefin polymer (COP), a silicone resin (SI), an acrylic resin, a phenol resin, an epoxy resin, a green sheet, a glass, and the like can be used. The wiring body 40 is attached to the supporting body 30, and the wiring body 40 is supported by the supporting body 30. In this case, it is preferable that the supporting body 30 has a rigidity enough to support the wiring body 40.

As illustrated in Fig. 2, the wiring body 40 includes a first resin portion 50, a first conductor portion 60, a second resin portion 70, a second conductor portion 80, and a third resin portion 90. In order to ensure the visibility of the display device, the wiring body 40 is configured so as to have transparency (translucency) as a whole.

The first resin portion 50 has a rectangular outer shape and is made of a resin material having transparency. As the resin material having transparency, for example, UV curable resins, thermosetting resin, or thermoplastic resins such as an epoxy resin, an acrylic resin, a polyester resin, a urethane resin, a vinyl resin, a silicone resin, a phenol resin, and a polyimide resin, can be exemplified. The lower surface of the first resin portion 50 is attached to the supporting body 30.

The first conductor portion 60 is provided on the upper surface of the first resin portion 50, and is retained by the first resin portion 50. The first conductor portion 60 includes a plurality of first electrode portions 61 and a plurality of first lead wiring 62.

Each of the first electrode portions 61 extends in the X direction in the figure, and the plurality of first electrode portions 61 are juxtaposed in the Y direction in the figure. Each of the first electrode portions 61 includes a plurality of first detection portions 613 and a plurality of first connection portions 614. The first detection portion 613 has a substantially rhombus (diamond) shape in a plane view. The plurality of first detection portions 613 are juxtaposed in the extension direction of the first electrode portion 61. The first connection portion 614 electrically connects the adjacent first detection portions 613 and 613 to each other.

One end of each of the first lead wirings 62 is connected to one end of each of the first electrode portions 61 in the longitudinal direction. The other end of each of the first lead wirings 62 extends to the edge portion of the wiring body 40. The other end of the first lead wiring 62 is connected to an external circuit. The number of the first electrode portions 61 is not particularly limited and can be arbitrarily set. The number of the first lead wirings 62 is set according to the number of the first electrode portions 61.

The first conductor portion 60 is made of a conductive material (conductive particles) and a binder resin. As the conductive material, metal materials such as silver, copper, nickel, tin, bismuth, zinc, indium, or palladium or carbon-based materials such as graphite, carbon black (furnace black, acetylene black, or ketjen black), carbon nanotube or carbon nanofiber can be exemplified. As a conductive material, a metal salt may be used. As the metal salt, salts of the above-mentioned metals can be exemplified. As the binder resin, an acrylic resin, a polyester resin, an epoxy resin, a vinyl resin, a urethane resin, a phenol resin, a polyimide resin, a silicone resin, a fluororesin, and the like can be exemplified. Such a first conductor portion 60 is formed by applying a conductive paste and curing the resulting product. As a specific example of such a conductive paste, a conductive paste formed by mixing the above-described conductive material and a binder resin in water or a solvent and various additives can be exemplified. As the solvent contained in the conductive paste, α-terpineol, butyl carbitol acetate, butyl carbitol, 1-decanol, butyl cellosolve, diethylene glycol monoethyl ether acetate, tetradecane and, the like can be exemplified. The binder resin may be omitted from the material constituting the first conductor portion 60.

The second resin portion 70 has a rectangular outer shape and is made of a resin material having transparency. As the resin material having transparency, for example, the same material as the resin material constituting the first resin portion 50 can be used.

The second resin portion 70 is provided on the first resin portion 50 so as to cover the first conductor portion 60. An opening 71 is formed in the second resin portion 70, and the other end of the first lead wiring 62 is exposed from the opening 71.

The second conductor portion 80 is provided on the upper surface of the second resin portion 70. The second conductor portion 80 includes a plurality of second electrode portions 81 and a plurality of second lead wirings 82. Each of the second electrode portions 81 extends in the Y direction in the figure, and the plurality of second electrode portions 81 are juxtaposed in the X direction in the figure. Each of the second electrode portions 81 includes a plurality of second detection portions 813 and a plurality of second connection portions 814. The second detection portion 813 has a substantially rhombus shape in a plane view. The plurality of second detection portions 813 are juxtaposed in the extension direction of the second electrode portion 81. The second connection portion 814 electrically connects the adjacent second detection portions 813 and 813 to each other.

One end of each of the second lead wirings 82 is connected to one end of each second electrode portion 81 in the longitudinal direction. The other end of each of the second lead wirings 82 extends to the edge portion of the wiring body 40. The other end of each of the second lead wirings 82 is connected to an external circuit. The number of the second electrode portions 81 is not particularly limited and can be arbitrarily set. The number of the second lead wirings 82 is set according to the number of the second electrode portions 81.

Similarly to the first conductor portion 60, the second conductor portion 80 is made of a conductive material (conductive particles) and a binder resin. Similarly to the first conductor portion 60, the second conductor portion 80 is also formed by applying a conductive paste and curing the resulting product.

The third resin portion 90 has a rectangular outer shape and is made of a resin material having transparency. As the resin material having transparency, for example, the same resin material as the resin material constituting the first resin portion 50 can be used.

The third resin portion 90 is provided on the second resin portion 70 so as to cover the second conductor portion 80. An opening 91 is formed in the third resin portion 90, and the other end of the second lead wirings 82 is exposed from the opening 91. The opening 91 overlaps the opening 71, and in this case, the other end of the first lead wirings 62 is also exposed from the opening 91. In the embodiment, as illustrated in Fig. 2, the external conductor F (finger F) is in contact with the third resin portion 90. However, the invention is not particularly limited thereto, and the touch sensor 10 may be configured to have a surface that the external conductor F is in contact with. For example, a cover glass may be stacked on the resin member 90, and a finger may be in contact with the cover glass.

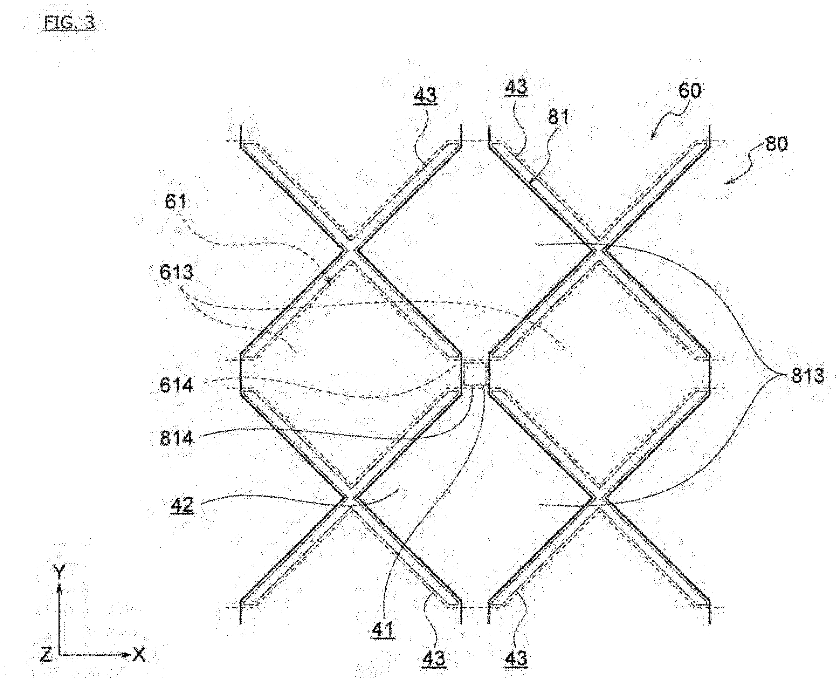

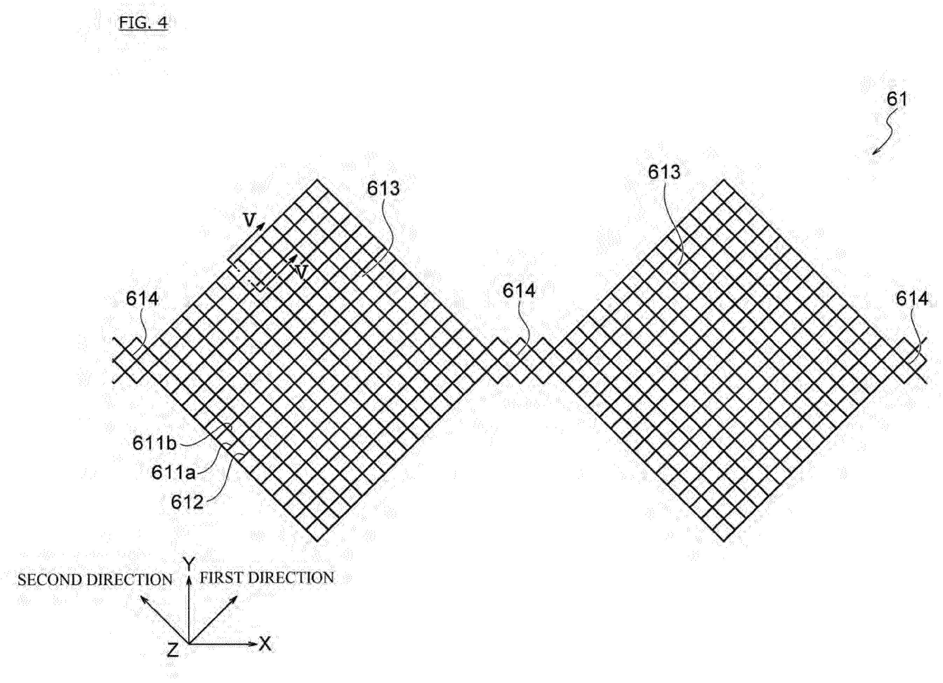

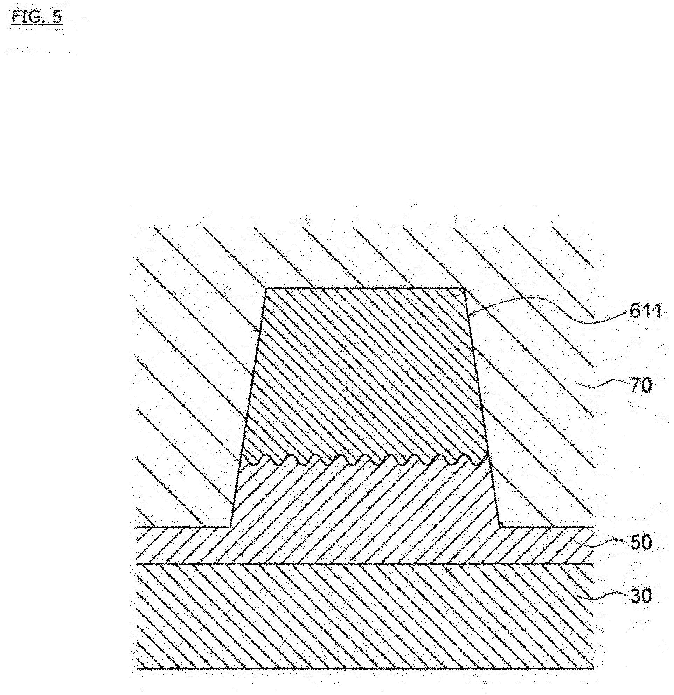

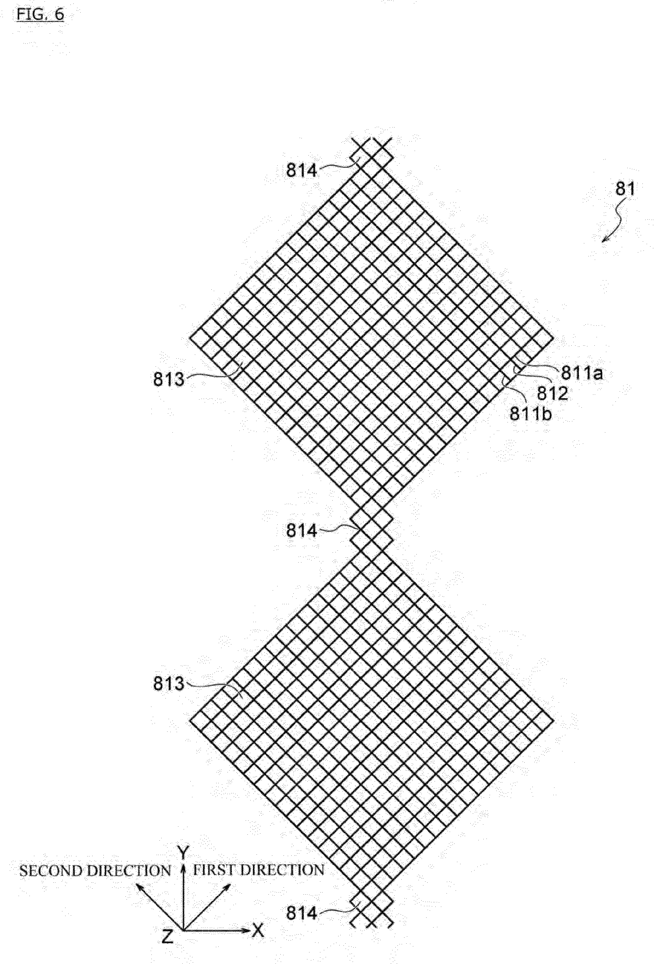

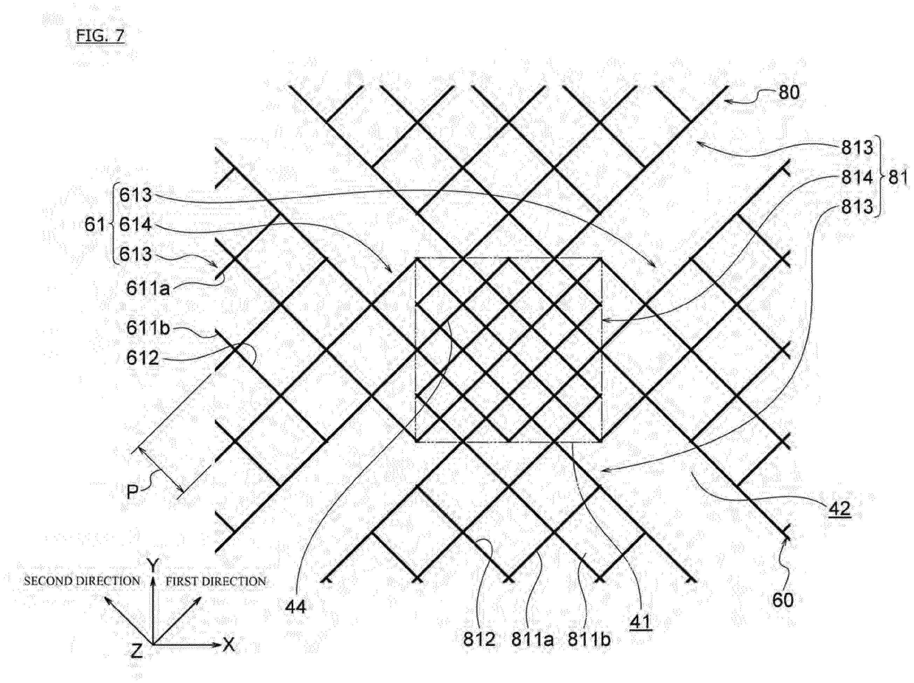

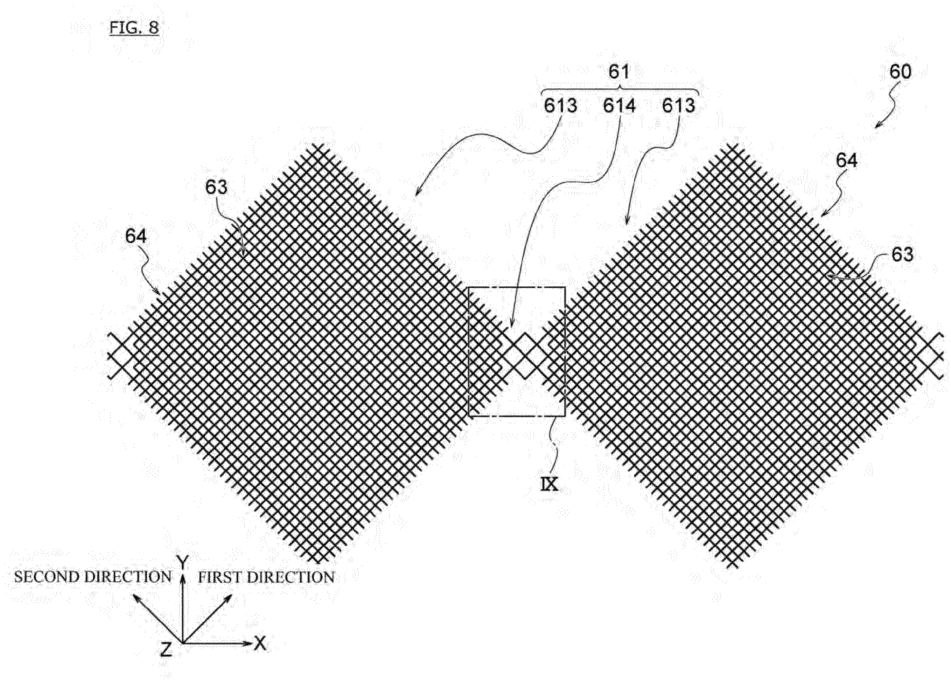

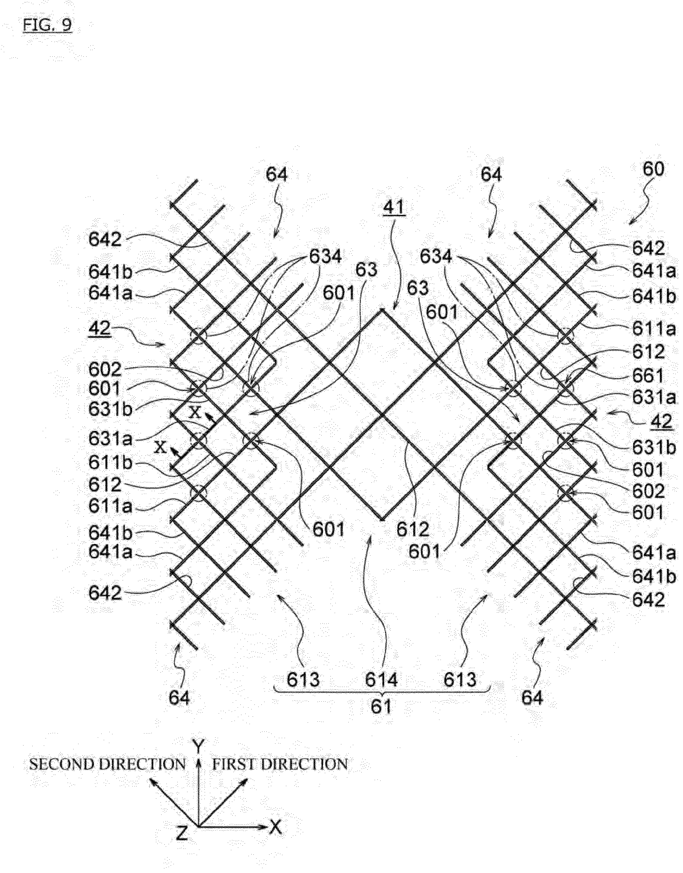

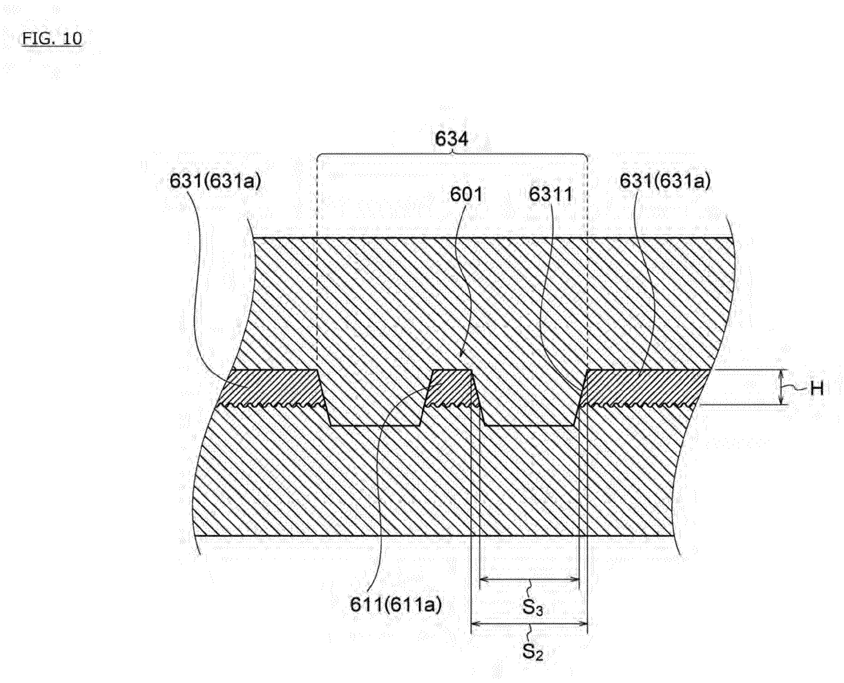

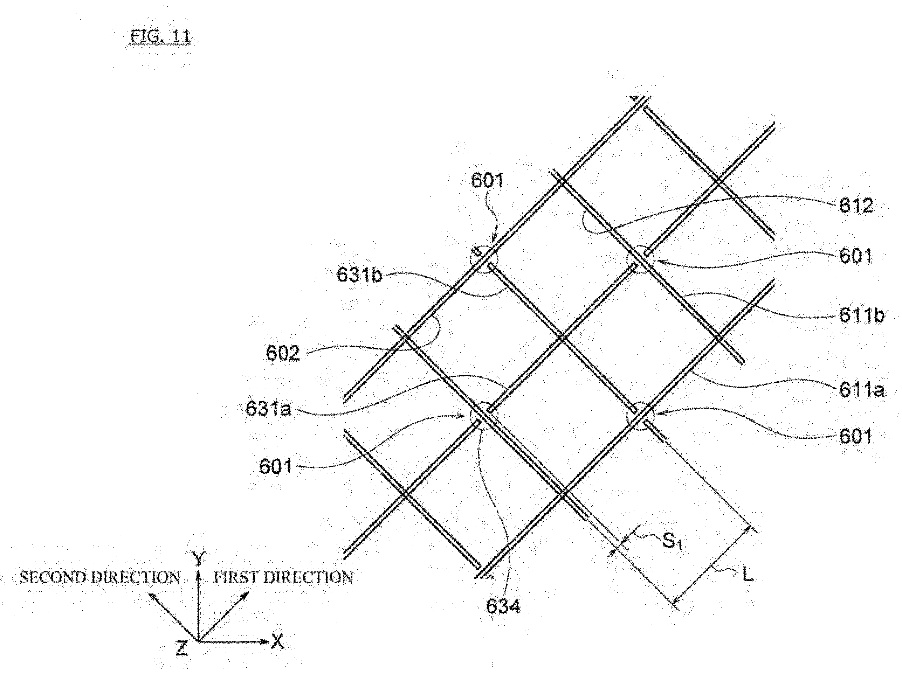

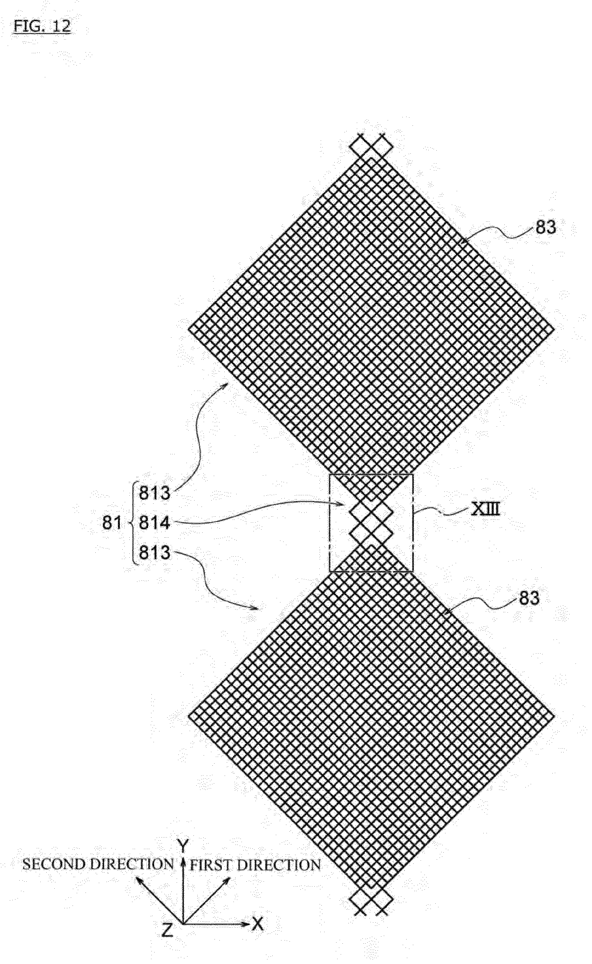

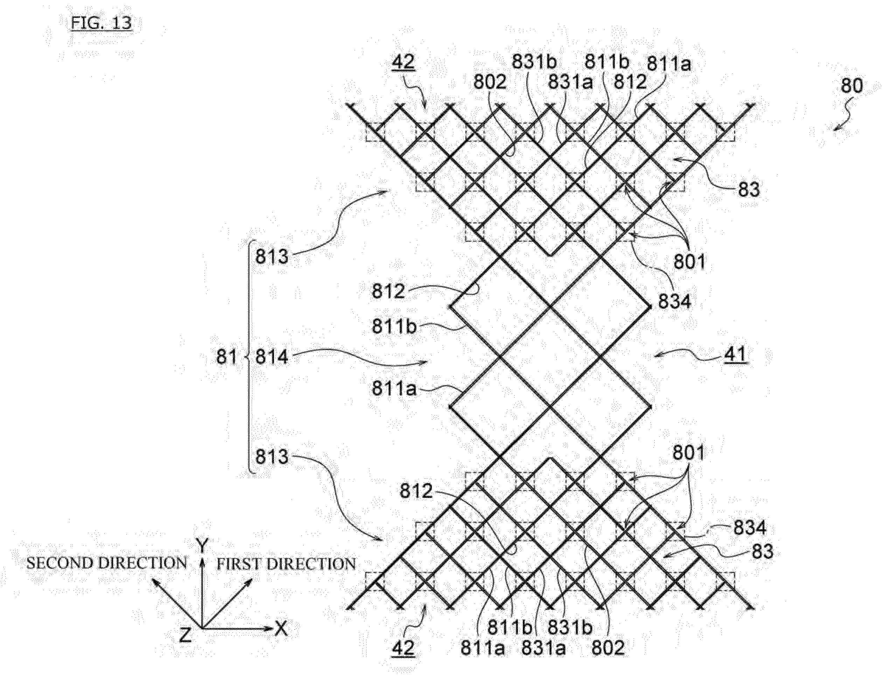

Next, the configurations of the first conductor portion 60 and the second conductor portion 80 will be described in more detail with reference to Figs. 3 to 11. Fig. 3 is a see-through (transmission, transparent) plan view illustrating the first electrode portion and the second electrode portion according to the first embodiment of the invention, Fig. 4 is a plan view illustrating the first electrode portion according to the first embodiment of the invention, Fig. 5 is a cross-sectional view taken along line V-V of Fig. 4, Fig. 6 is a plan view illustrating the second electrode portion according to the first embodiment of the invention, Fig. 7 is an enlarged see-through plan view illustrating the overlapping region of the first electrode portion and the second electrode portion according to the first embodiment of the invention, Fig. 8 is a plan view illustrating the first conductor portion according to the first embodiment of the invention, Fig. 9 is a partial enlarged view of an IX portion of Fig. 8, Fig. 10 is a cross-sectional view taken along line XX of Fig. 9, Fig. 11 is a plan view illustrating the first electrode portion and a first dummy electrode portion according to the first embodiment of the invention, Fig. 12 is a plan view illustrating a second conductor portion according to the first embodiment of the invention, and Fig. 13 is a partially enlarged view of an XIII portion of Fig. 12. In Figs. 9 and 11, a portion surrounded by a circle with one-dot dashed line indicates a second disconnection portion 634 (described later). In Fig. 13, a portion surrounded by a rectangular frame with a one-dot dashed line indicates a fourth disconnection portion 834 (described later).

As illustrated in Figs. 1 and 2, in the wiring body 40, the first conductor portion 60 is disposed on one side of the second resin portion 70, and the second conductor portion 80 is disposed on the other side of the second resin portion 70. The second conductor portion 80 is disposed at a position closer to the side with which the external conductor F is in contact than the first conductor portion 60. That is, the first conductive portion 60 is located on the display device side, and the second conductive portion 80 is located on the operator side (the side with which the external conductor F is in contact). The first electrode portion 61 and the second electrode portion 81 face each other with the second resin portion 70 interposed therebetween. In this case, as illustrated in Fig. 3, in a see-through plane view, a region (hereinafter, also referred to as an "overlapping region 41") where the first electrode portion 61 and the second electrode portion 81 partially overlap exists in the wiring body 40.

In the embodiment, the first connection portion 614 and the second connection portion 814 are disposed in the overlapping region 41 (that is, the first connection portion 614 and the second connection portion 814 overlap each other in a see-through plane view). The first detection portion 613 and the second detection portion 813 are disposed in a region (hereinafter, also referred to as a "non-overlapping region 42") other than the overlapping region 41 of the first electrode portion 61 or the second electrode portion 81 (that is, the first detection portion 613 and the second detection portion 813 do not overlap each other in a see-through plane view).

As illustrated in Fig. 4, the first electrode portion 61 has a plurality of first thin lines 611a and 611b having a linear shape. In the following description, the first thin lines 611a and 611b are collectively referred to as the first thin lines 611, as necessary.

As illustrated in Fig. 5, the first thin line 611 protrudes from the upper surface of the first resin portion 50. The first thin line 611 has a tapered shape that gradually becomes narrower as going far away from the first resin portion 50 at the time of viewing a cross section cut along the width direction of the first thin line 611. In the first thin line 611, a portion in contact with the first resin portion 50 is relatively rough with respect to a portion in contact with the second resin portion 70. Specifically, the surface roughness Ra of the portion in contact with the first resin portion 50 is 0.1 $\mu$m to 3 $\mu$m, and the surface roughness Ra of the portion in contact with the second resin portion 70 is 0.001 $\mu$m to 1.0 $\mu$m. The surface roughness Ra refers to an "arithmetic average roughness Ra" defined by JIS method (JIS B0601 (revised March 21, 2013)).

Returning to Fig. 4, the plurality of first thin lines 611a extend in a direction (hereinafter, also referred to as a "first direction") intersecting the extension direction of the first electrode portion 61 and are juxtaposed at a pitch P in a direction (hereinafter, also referred to as a "second direction") perpendicular to the first direction. The plurality of first thin lines 611b extend in the second direction and are juxtaposed in the first direction at the same pitch as the pitch P. Since the plurality of first thin lines 611a and 611b are perpendicular to each other, a first lattice 612 having a rhombus shape formed by the plurality of first thin lines 611a and 611b is repeatedly disposed over the entire first electrode portion 61. In this specification, the pitch of thin lines denotes the distance between centers of adjacent thin lines.

No first thin line 611 protruding into the first lattice 612 exists in the first electrode portion 61 of the embodiment. No first thin line 611 protruding from the outline of the first electrode portion 61 exists. In this case, the end portions of all the first thin lines 611 are closed by being in contact with the end portions of the other first thin lines 611, and all the first thin lines 611 constitute at least a portion of the first lattice 612. In the first electrode portion 61, the width and the pitch of the first thin lines 611 are uniform. For this reason, the width and the pitch of the first thin lines 611 constituting the first detection portion 613 and the first connection portion 614 are not changed between the first detection portion 613 and the first connection portion 614.

As illustrated in Fig. 6, the second electrode portion 81 has a plurality of second thin lines 811a and 811b having a linear shape. The second thin lines 811a and 811b have the same shape as the first thin line 611. The plurality of second thin lines 811a extend in the same first direction as the first thin lines 611a and are juxtaposed in the second direction at the same pitch as the pitch P. The plurality of second thin lines 811b extend in the same second direction as the first thin lines 611b and are juxtaposed in the first direction at the same pitch as the pitch P. Since the plurality of second thin lines 811a and 811b are perpendicular to each other, the second lattice 812 having a rhombus shape formed by the plurality of second thin lines 811a and 811b is repeatedly disposed over the entire second electrode portion 81. This second lattice 812 has substantially the same shape as the first lattice 612. In the following description, the second thin lines 811a and 811b are collectively referred to as second thin lines 811 as necessary.

No second thin line 811 protruding into the second lattice 812 exists in the second electrode portion 81 of the embodiment. No second thin line 811 protruding from the outline of the second electrode portion 81 also exists. In this case, the end portions of all the second thin lines 811 are closed by being in contact with the end portions of the other second thin lines 811, and all the second thin lines 811 constitute at least a portion of the second lattice 812. In the second electrode portion 81, the width and the pitch of the second thin lines 811 are uniform. For this reason, the width and the pitch of the second thin lines 811 constituting the second detection portion 813 and the second connection portion 814 are not changed between the second detection portion 813 and the second connection portion 814.

In a see-through plane view, as illustrated in Fig. 7, each of the second thin lines 811a is disposed so as to be shifted from the adjacent first thin line 611a by a half of the pitch P in the second direction. In a see-through plane view, each of the second thin lines 811b is disposed so as to be shifted from the adjacent first thin lines 611b by a half of the pitch P in the first direction. Accordingly, in a see-through plane view, the first thin line 611 and the second thin line 811 overlap each other so as to intersect each other in the overlapping region 41, so that a plurality of third lattices 44 having a rhombus shape formed in a similar shape to the first lattice 612 and the second lattice 812 are formed.

In this case, as illustrated in Fig. 7, in a see-through plane view, the area occupied by the first thin line 611 and the second thin line 811 per unit area in the overlapping region 41 of the first electrode portion 61 is larger than the area occupied by the first thin line 611 in the non-overlapping region 42. Similarly, in a see-through plane view, the area occupied by the first thin line 611 and the second thin line 811 per unit area in the overlapping region 41 of the second electrode portion 81 is larger than the area occupied by the second thin line 811 in the non-overlapping region 42.

As illustrated in Figs. 8 and 9, the first conductor portion 60 includes a first dummy electrode portion 63. The first dummy electrode portion 63 is located on the same plane as the first electrode portion 61. The first dummy electrode portion 63 has a plurality of third thin lines 631a and 631b having a linear shape. The third thin lines 631a and 631b have the same shape as the first thin line 611. The third thin lines 631a extend in the same first direction as the first thin line 611a and are juxtaposed in the second direction at the same pitch as the pitch P. The third thin lines 631b extend in the same second direction as the first thin line 611b and are juxtaposed in the first direction at the same pitch as the pitch P. In the following description, the third thin lines 631a and 631b are collectively referred to as third thin lines 631 as necessary.

The first dummy electrode portion 63 includes the second disconnection portion 634 in which the third thin line 631 is not formed at all the intersections 601 of the first thin line 611 and the third thin line 631 (strictly speaking, the intersections 601 of the first thin line 611 and the extension line of the third thin line 631),. The first electrode portion 61 and the first dummy electrode portion 63 are electrically insulated from each other by the second disconnection portion 634.

As illustrated in Fig. 10, the end surface 6311 of the third thin line 631 faces the first thin line 611 via the second disconnection portion 634. The end surface 6311 is inclined so as to be far away from the first thin line 611 as going far away from the first resin portion 50. In this case, in the second disconnection portion 634, the interval between the first thin line 611 and the third thin line 631 becomes smallest at the lower ends (the side closest to the first resin portion 50) of the first thin line 611 and the third thin line 631 and becomes largest at the upper end (the side furthest from the first resin portion 50) of the first thin line 611 and the third thin line 631.

In the embodiment, it is preferable that, in one of the second disconnection portions 634, the relationship among the maximum interval $S_2$ between the first thin line 611 and the third thin line 631, the minimum interval $S_3$ between the first thin line 611 and the third thin line 631, and the height H of the third thin line 631 satisfies the following formulas (4) and (5).

$$(S_2 - S_3) \times 0.5/H \leq 1 \ldots (4)$$

$$S_3 < 50 \ \mu m \ldots (5)$$

As illustrated in Fig. 9, the first dummy electrode portion 63 exists in the first lattice 612 of the first electrode portion 61 in the non-overlapping region 42. In the embodiment, as the first dummy electrode portion 63, the cross-shaped patterns formed by the individual third thin lines 631a and 631b divided by the second disconnection portion 634 exist in all the first lattices 612 constituting the first detection portion 613. In addition, as the first dummy electrode portion 63, the L-shaped patterns formed by the individual third thin lines 631a and 631b divided by the second disconnection portion 634 exist in the first lattice 612 located at the boundary between the first detection portion 613 and the first connection portion 614.

In a plane view, each of the third thin lines 631a is disposed so as to be shifted from the adjacent first thin line 611a by a half of the pitch P in the second direction. In a plane view, each of the third thin lines 631b is disposed so as to be shifted from the adjacent first thin line 611b by a half of the pitch P in the first direction. Accordingly, in a plane view, by combining the first thin line 611 and the third thin line 631 (strictly speaking, an extension line of the third thin line 631) in the non-overlapping region 42, a plurality of fourth lattices 602 having a rhombus shape formed in a similar shape to the first lattice 612 are formed. The fourth lattice 602 has substantially the same shape as the third lattice 44 (refer to Fig. 7).

In the embodiment, as illustrated in Fig. 11, it is preferable that the relationship among the interval $S_1$ between the first thin line 611 and the third thin line 631 at the second disconnection portion 634 and the length L of one side of the fourth lattice 602, satisfies the following formula (6). The interval $S_1$ denotes an average value of the intervals between the first thin line 611 and the third thin line 631 in one of the second disconnection portions 634. The length L is the center-to-center distance between the first thin line and the third thin line adjacent to the first thin line.

$$S_1 \leq L/10 \ldots (6)$$

As illustrated in Figs. 12 and 13, the second conductor portion 80 includes a second dummy electrode portion 83. The second dummy electrode portion 83 is located on the same plane as the second electrode portion 81. The second dummy electrode portion 83 has a plurality of fourth thin lines 831a and 831b having a linear shape. The fourth thin lines 831a and 831b have the same shape as the second thin line 811. The fourth thin lines 831a extend in the same first direction as the first thin line 611a and are juxtaposed in the second direction at the same pitch as the pitch P. The fourth thin lines 831b extend in the same second direction as the first thin line 611b and are juxtaposed in the first direction at the same pitch as the pitch P. In the following description, the fourth thin lines 831a and 831b are collectively referred to as fourth thin lines 831 as necessary.

The second dummy electrode portion 83 includes the fourth disconnection portion 834 in which the fourth thin lines 831 are not formed at all intersections 801 of the second thin line 811 and the fourth thin line 831 (strictly speaking, intersections 801 of the second thin line 811 and the extension lines of the fourth thin line 831). The second electrode portion 81 and the second dummy electrode portion 83 are electrically insulated by the fourth disconnection portion 834.

The second dummy electrode portion 83 exists in the second lattice 812 of the second electrode portion 81 in the non-overlapping region 42. In the embodiment, as the second dummy electrode portion 83, the cross-shaped patterns formed by the individual fourth thin lines 831a and 831b divided by the fourth disconnection portion 834 exist in all the second lattices 812 constituting the second detection portion 813. In addition, as the second dummy electrode portion 83, L-shaped patterns formed by the individual fourth thin lines 831a and 831b divided by the fourth disconnection portion 834 exist in the second lattice 812 located at the boundary between the second detection portion 813 and the second connection portion 814.

In a plane view, each of the fourth thin lines 831a is disposed so as to be shifted from the adjacent second thin line 811a by a half of the pitch P in the second direction. In a plane view, each of the fourth thin lines 831b is disposed so as to be shifted from the adjacent second thin line 811b by a half of the pitch P in the first direction. Accordingly, in a plane view, by combining the second thin line 811 and the fourth thin line 831 (strictly speaking, an extension line of the fourth thin line 831) in the non-overlapping region 42, a plurality of sixth lattices 802 having a rhombus shape formed in a similar shape to the second lattice 812 are formed. The sixth lattice 802 has substantially the same shape as the third lattice 44 (refer to Fig. 7).

As illustrated in Fig. 3, in a see-through plane view, the non-overlapping region 42 includes a region (hereinafter, also referred to as a gap region 43) which does not overlap both the first electrode portion 61 and the second electrode portion 81 and which is between the first electrode portion 61 and the second electrode portion 81. A third dummy electrode portion 64 exists in the gap region 43.

As illustrated in Figs. 8 and 9, the third dummy electrode portion 64 of the embodiment is included in the first conductor portion 60. In this case, the third dummy electrode portion 64 is located on the same plane as the first electrode portion 61. The first electrode portion 61 and the third dummy electrode portion 64 are separated from each other, so that the first electrode portion 61 and the third dummy electrode portion 64 are electrically insulated.

The third dummy electrode portion 64 has a plurality of fifth thin lines 641a and 641b having a linear shape. The fifth thin lines 641a and 641b have the same shape as the first thin lines 611. The fifth thin lines 641a extend in the same first direction as the first thin line 611 and are juxtaposed in the second direction at a pitch half the pitch P. The fifth thin lines 641b extend in the same second direction as the first thin line 611b and are juxtaposed in the first direction at a pitch of a half of the pitch P. Since the plurality of fifth thin lines 641a and 641b are perpendicular to each other, the fifth lattice 642 having a rhombus shape formed by the plurality of fifth thin lines 641a and 641b is repeatedly disposed on the entire third dummy electrode portion 64. The fifth lattice 642 has substantially the same shape as the third lattice 44 (refer to Fig. 7). In the following description, the fifth thin lines 641a and 641b are generically referred to as fifth thin lines 641 as necessary.

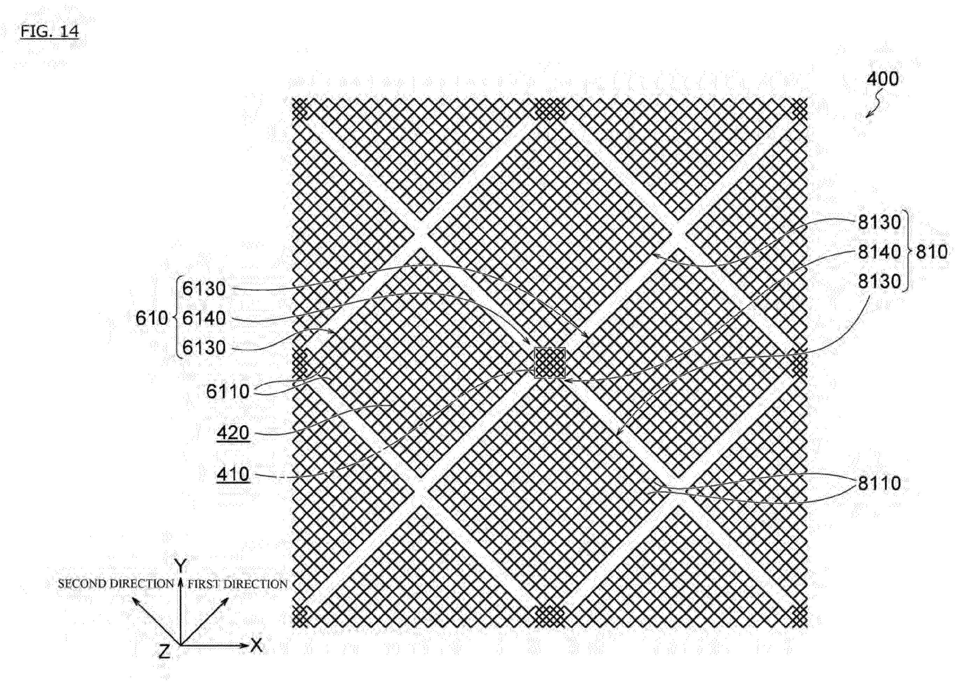

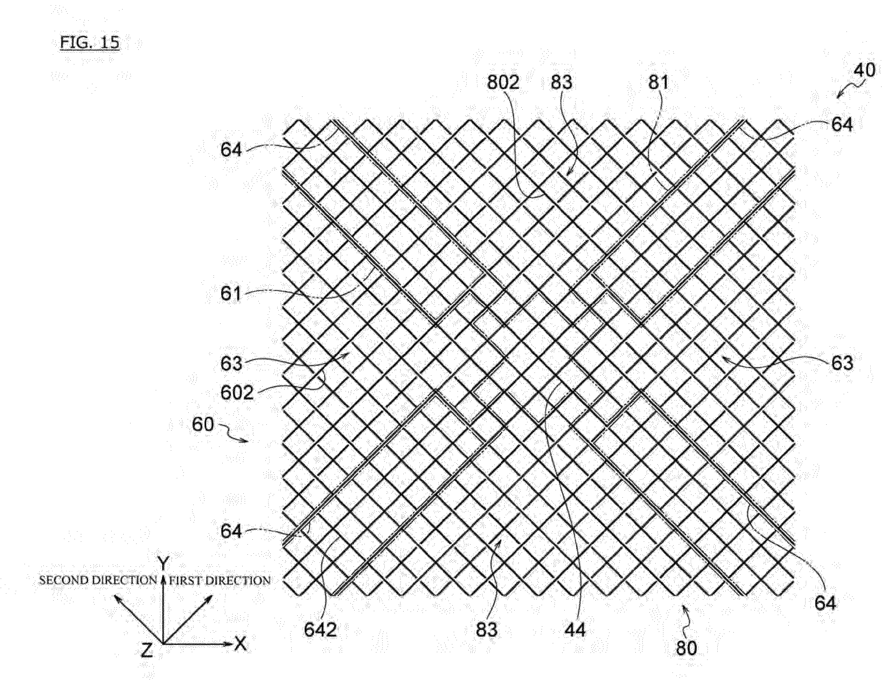

The wiring body 40 of the embodiment has the following effects. Fig. 14 is a see-through plan view illustrating a first conductor portion and a second conductor portion according to Comparative Example, and Fig. 15 is a see-through plan view illustrating the first conductor portion and the second conductor portion according to the first embodiment of the invention.

In the wiring body 400 according to Comparative Example illustrated in Fig. 14, in a first electrode portion 610, the width and the pitch of first thin lines 6110 constituting a first detection portion 6130 and a first connection portion 6140 are not changed between the first detection portion 6130 and the first connection portion 6140. In addition, in the second electrode portion 810, the width and the pitch of second thin lines 8110 constituting a second detection portion 8130 and a second connection portion 8140 are not changed between the second detection portion 8130 and the second connection portion 8140. For this reason, in a see-through plane view, the area occupied by the first thin line 6110 and the second thin line 8110 per unit area in an overlapping region 410 of the first electrode portion 610 is larger than the area occupied by the first thin line 6110 in a non-overlapping region 420. In this case, since there is a difference in light shielding ratio between the overlapping region 410 and the non-overlapping region 420, there is a concern that the visibility of the wiring body 400 is deteriorated.

In contrast, in the embodiment, the first dummy electrode portion 63 is located on the same plane as the first electrode portion 61, and the first dummy electrode portion 63 exists in the first lattice 612 in the non-overlapping region 42. Accordingly, since the difference in light shielding rate between the overlapping region 41 and the non-overlapping region 42 becomes small, the visibility of the wiring body 40 is improved. Furthermore, in the embodiment, since the width and pitch of the first thin lines 611 are not changed between the first detection portion 613 and the first connection portion 614, it is difficult for a decease in the conduction path at the first connection portion 614 to occur. Since the first dummy electrode portion 63 is located on the same plane as the first electrode portion 61, it is difficult for the parasitic capacitance between the first electrode portion 61 and the first dummy electrode portion 63 to occur. Accordingly, it is possible to improve the sensor sensitivity of the wiring body 40.

In the embodiment, the second conductor portion 80 also includes the second dummy electrode portion 83 which is located on the same plane as the second electrode portion 81 and exists in the second lattice 812 in the non-overlapping region 42. Accordingly, the second conductor portion 80 can also obtain the same functions and effects as those obtained by the above-described first conductor portion 60.

In the embodiment, a plurality of third lattices 44 are formed by overlapping the first thin line 611 and the second thin line 811 each other in the overlapping region 41, a plurality of fourth lattices 602 is formed by combining the first thin line 611 and the third thin line 631 in the non-overlapping region 42, and the fourth lattice 602 has substantially the same shape as the third lattice 44. Accordingly, in the first electrode portion 61, a uniform conductive pattern is formed in which the third lattice 44 and the fourth lattice 602 which have the same shape are repeatedly disposed over the region from the overlapping region 41 to the non-overlapping region 42 in outer appearance. As a result, it is possible to further improve the visibility of the wiring body 40.

In the embodiment, a plurality of sixth lattices 802 are formed by combining the second thin line 811 and the fourth thin line 831 in the non-overlapping region 42, and the sixth lattice 802 has substantially the same shape as the third lattice 44. Accordingly, in the second electrode portion 81, a uniform conductive pattern is formed in which the third lattice 44 and the sixth lattice 802 which have the same shape are repeatedly disposed over the region from the overlapping region 41 to the non-overlapping region 42 in outer appearance. As a result, it is possible to further improve the visibility of the wiring body 40.

In the embodiment, all the first thin lines 611 constitute at least a portion of the first lattice 612, and the first dummy electrode portion 63 includes the second disconnection portion 634 formed at all the intersections 601 of the first thin line 611 and the third thin line 631, so that the above-mentioned formula (6) is satisfied. Accordingly, it is possible to more reliably electrically insulate the first electrode portion 61 and the first dummy electrode portion 63, and it is possible to make the second disconnection portion 634 inconspicuous. As a result, it is possible to further improve the visibility of the wiring body 40, and it is possible to further improve the sensor sensitivity of the wiring body 40.

In the embodiment, since the end surfaces 6311 are formed in an upright shape by further satisfying the formulas (4) and (5), it is difficult to induce charges on the end surfaces 6311 of the third thin lines 631. Accordingly, it is possible to suppress short-circuiting between the first electrode portion 61 and the first dummy electrode portion 63. In addition, it is possible to make the second disconnection portion 634 more inconspicuous.

As a result, it is possible to further improve the visibility of the wiring body 40, and it is possible to further improve the sensor sensitivity of the wiring body 40.

In the embodiment, the third dummy electrode portion 64 that is located on the same plane as the first electrode portion 61 and electrically insulated from the first electrode portion 61 exists in the gap region 43, and thus, the difference in light shielding ratio becomes small between the region where at least one of the first electrode portion 61 and the second electrode portion 81 exists and the region (that is, the gap region 43) where neither the first electrode portion 61 nor the second electrode portion 81, so that it is possible to further improve the visibility of the wiring body 40.

In the embodiment, the fifth lattice 642 included in the third dummy electrode portion 64 has substantially the same shape as the third lattice 44, so that as illustrated in Fig. 15, a uniform conductor pattern is formed in which the third lattice 44, the fourth lattice 602, the fifth lattice 642, and the sixth lattice 802 which have the same shape are repeatedly disposed over the entire display region of the wiring body 40 in outer appearance. Accordingly, it is possible to further improve the visibility of the wiring body 40.

In the embodiment, the first thin line 611, the second thin line 811, the third thin line 631, the fourth thin line 831, and the fifth thin line 641 included in the first conductor portion 60 and the second conductor portion 80 have the same shape, and relatively coarse portions of these thin lines are disposed at the same side of the wiring body 40. For this reason, since the tone of the conductive pattern is uniform in the display region of the touch sensor 10, the visibility of the touch sensor 10 is further improved.

In the embodiment, no first thin line 611 protruding from the outline of the first electrode portion 61 exists. In this case, the end portions of all the first thin lines 611 are closed by being in contact with the end portions of the other first thin lines 611. For this reason, the outline of the first electrode portion 61 becomes clear, and a clear space is formed between the first electrode portion 61 and the second electrode portion 81 in a plane view, so that it is possible to improve the sensor sensitivity of the wiring body 40. In the embodiment, there is also no second thin line 811 protruding from the outline of the second electrode portion 81. In this case, the end portions of all the second thin lines 811 are closed by being in contact with the end portions of the other second thin lines 811. For this reason, the outline of the second electrode portion 81 becomes clear, and a clear space is formed between the second electrode portion 81 and the first electrode portion 61 in a plane view, so that it is possible to further improve the sensor sensitivity of the wiring body 40.

The "touch sensor 10" in the embodiment corresponds to an example of the "touch sensor" in the invention, the "wiring board 20" in the embodiment corresponds to an example of the "wiring board" in the invention, the "supporting body 30" in the embodiment corresponds to an example of the "supporting body" in the invention, the "wiring body 40" in the embodiment corresponds to an example of the "wiring body" in the invention, the "second resin portion 70" in the embodiment corresponds to an example of the "insulating portion" in the invention, the "first conductor portion 60 "in the embodiment corresponds to an example of the "first conductor portion" in the invention, the "second conductor portion 80" in the embodiment corresponds to an example of the "second conductor portion" in the invention, the "first electrode portion 61" in the embodiment corresponds to the "first electrode portion" in the invention, the "first detection portion 613" in the embodiment corresponds to an example of the "first detection portion" in the invention, the "first connection portion 614" in the embodiment corresponds to an example of the "first connection portion" in the invention, the "first thin line 611" in the embodiment corresponds to an example of the "first thin line" in the invention, the "first lattice 612" in the embodiment corresponds to an example of the "first lattice" in the invention, the" second electrode portion 81 "in the embodiment corresponds to an example of the "second electrode portion" in the invention, the "second detection portion 813" in the embodiment corresponds to an example of the "second detection portion" in the invention, the "second connection portion 814" in the embodiment corresponds to an example of the "second connection portion" in the invention, the "second thin line 811" in the embodiment corresponds to an example of the "second thin line" in the invention, the "second lattice 812" in the embodiment corresponds to an example of the "second lattice" in the invention, the "third lattice 44" in the embodiment corresponds to an example of the "third lattice" in the invention, the "overlapping region 41" in the embodiment corresponds to an example of the "overlapping region" in the invention, and the "non-overlapping region 42" in the embodiment corresponds to an example the "overlapping region" in the invention.

The "first dummy electrode portion 63" in the embodiment corresponds to an example of the "first dummy electrode portion" in the invention, the "third thin line 631" in the embodiment corresponds to an example of the "third thin line" in the invention, the "second disconnection portion 634" in the embodiment corresponds to an example of the "second disconnection portion" in the invention, the "fourth lattice 602" in the embodiment corresponds to an example of the "fourth lattice" in the invention, and the "second dummy electrode portion 83" in the embodiment corresponds to an example of the "second dummy electrode portion" in the invention.

The "gap region 43" in the embodiment corresponds to an example of the "gap region" in the invention, the "third dummy electrode portion 64" in the embodiment corresponds to an example of the "third dummy electrode portion" in the invention, and the "fifth lattice 641" in the embodiment corresponds to an example of the "fifth lattice" in the invention.

[Second Embodiment]

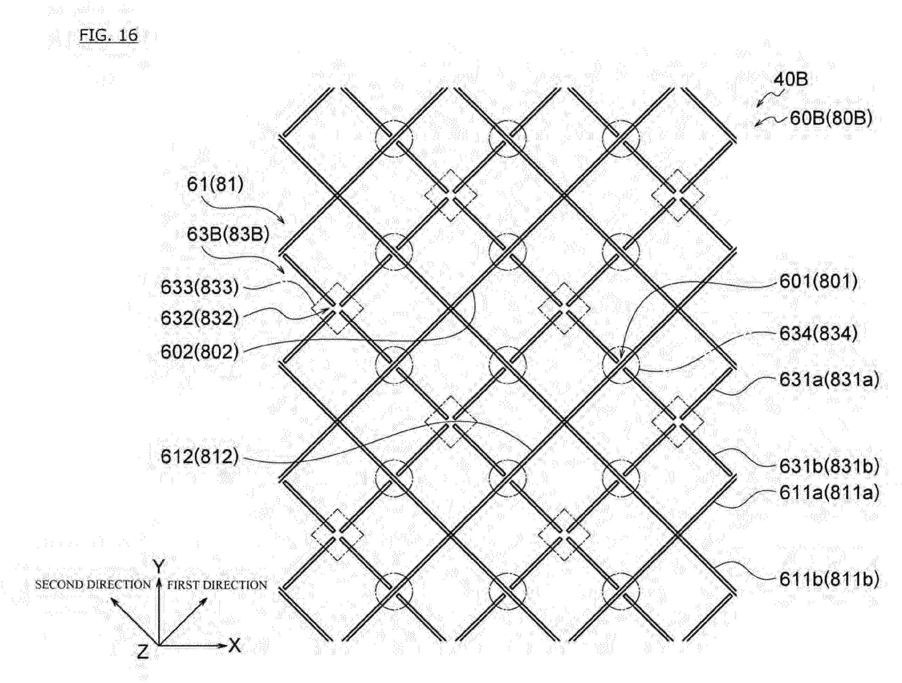

Fig. 16 is a plan view illustrating a first conductor portion and a first dummy electrode portion according to a second embodiment of the invention. The same components as those in the above-described embodiment are denoted by the same reference numerals, the redundant description is omitted, and the description in the above-described embodiment is used. In Fig. 16, a portion surrounded by a rhombus-shaped frame with one-dot dashed line indicates a first disconnection portion 633 (described later).

In a first conductor portion 60B according to Fig. 16, a first dummy electrode portion 63B includes a first disconnection portion 633 formed at an intersection 632 between the third thin lines 631 (strictly speaking, an intersection 632 between an extension line of the third thin line 631a and an extension line of the third thin line 631b). Since the third thin line 631 is individually divided and shortened by the first disconnection portion 633, it is difficult to induce the charges in the third thin line 631. Accordingly, it is possible to further improve the sensor sensitivity of a wiring body 40B. Since it is difficult to induce the charges in the third thin line 631, it is possible to suppress short-circuiting between the first thin line 611 and the third thin line 631. As a result, it is possible to further improve the sensor sensitivity of the wiring body 40B.

Similarly to the first dummy electrode portion 63B, a second dummy electrode portion 83B may include a third disconnection portion 833 formed at an intersection 832 of the fourth thin lines 831. Accordingly, it is possible to further improve the sensor sensitivity of the wiring body 40B. Although the first conductor portion 60B and a second conductor portion 80B are slightly different, the basic configurations are the same. Therefore, the first conductor portion 60B is illustrated in Fig. 16, the second conductor portion 80B is indicated by the same reference numeral in parenthesis, and the illustration thereof is omitted.

The "first disconnection portion 633" in the embodiment corresponds to an example of the "first disconnection portion" in the invention.

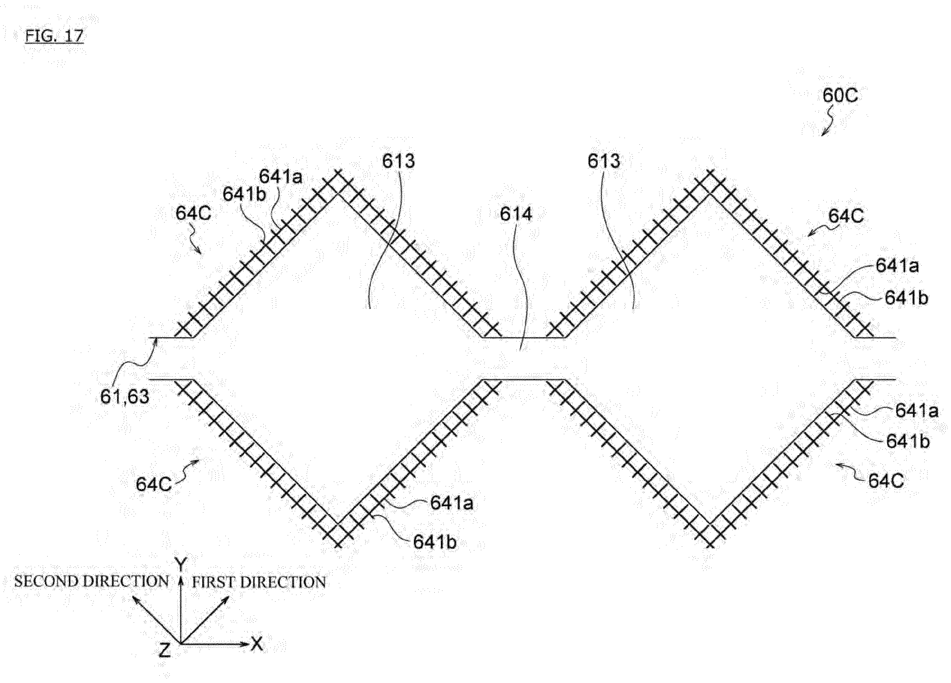

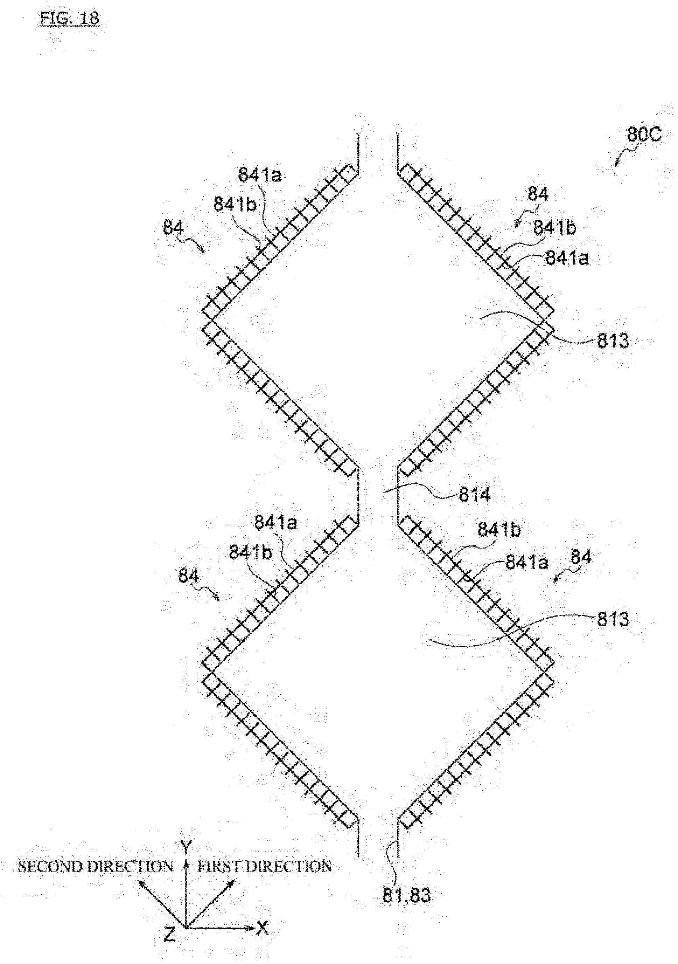

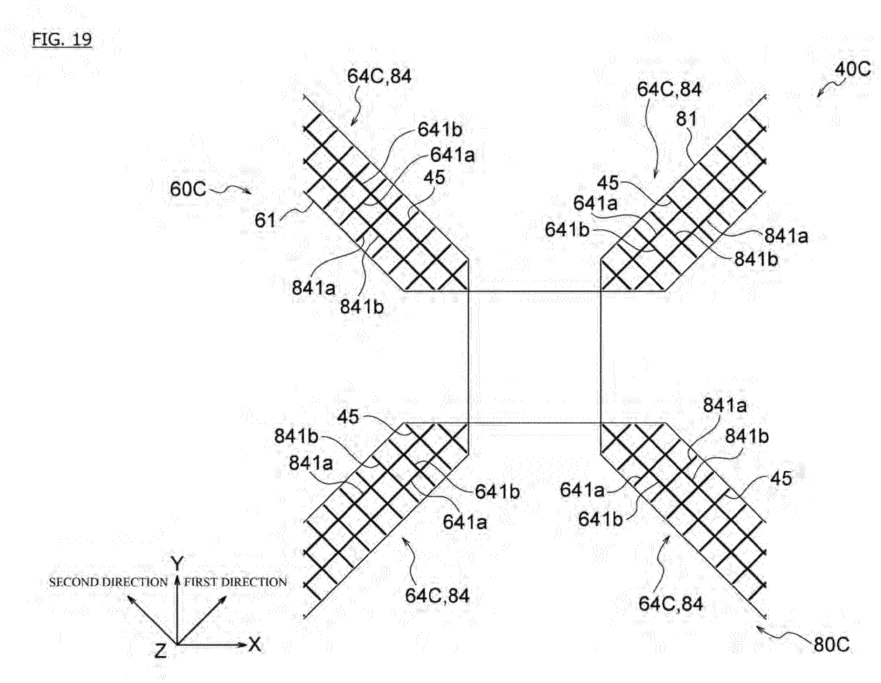

Fig. 17 is a plan view illustrating a first conductor portion according the second embodiment of the invention, Fig. 18 is a plan view illustrating a second conductor portion according to the second embodiment of the invention, Fig. 19 is a see-through plan view illustrating the first conductor portion and the second conductor portion according to the second embodiment of the invention. The same components as those in the above-described embodiment are denoted by the same reference numerals, the redundant description is omitted, and the description in the above-described embodiment is used. In Fig. 17, in order to describe a third dummy electrode portion 64C of the embodiment for the easier understanding, only the outline of the first electrode portion 61 is illustrated, and the detailed illustration of the first electrode portion 61 and the first dummy electrode portion 63 is omitted. Similarly, in Fig. 18, in order to describe a fourth dummy electrode portion 84 of the embodiment for the easier understanding, only the outline of the second electrode portion 81 is illustrated, and the detailed illustration of the second electrode portion 81 and the second dummy electrode portion 83 is omitted.

A first conductor portion 60C according to Fig. 17 includes the third dummy electrode portion 64C. The third dummy electrode portion 64C has a plurality of the fifth thin lines 641 having a linear shape. A second conductor portion 80C according to Fig. 18 includes the fourth dummy electrode portion 84 electrically insulated from the second electrode portion 81. The fourth dummy electrode portion 84 is located on the same plane as the second electrode portion 81 and exists in the gap region 43. The fourth dummy electrode portion 84 has a plurality of sixth thin lines 841 having a linear shape.

The plurality of fifth thin lines 641 extend in the first direction and the second direction and are disposed at the same pitch as the pitch P. The plurality of sixth thin lines 841 also extend in the first direction and the second direction and are disposed at the same pitch as the pitch P. In a see-through plane view, the fifth thin lines 641 and the sixth thin lines 841 are disposed so as not to overlap each other.

In the embodiment, as illustrated in Fig. 19, a plurality of rhombus-shaped seventh lattice 45 having substantially the same shape as the third lattice 44 are formed by combining the fifth thin line 641 (strictly speaking, the extension line of the fifth thin line 641) and the sixth thin line 841 (strictly speaking, the extension line of the sixth thin line 841) in the gap region 43.

Similarly to the above-described embodiment, also in the embodiment, since the light shielding rate becomes small between the region where at least one of the first electrode portion 61 and the second electrode portion 81 exists and the region (that is, the gap region 43) where neither the first electrode portion 61 nor the second electrode portion 81 exists, the visibility of a wiring body 40C can be further improved. Accordingly, since the third lattice 44, the fourth lattice 602, the sixth lattice 802, and the seventh lattice 45 which have the same shape are repeatedly disposed over the entire display region of the wiring body 40C in outer appearance, the visibility of the wiring body 40C can be improved.

The "third dummy electrode portion 64" and the "fourth dummy electrode portion 84" in the embodiment correspond to examples of the "third dummy electrode portion" in the invention, the " fifth thin line 641" and the "sixth thin line 841" in the embodiment correspond to examples of the "fifth thin line" in the invention, and the "seventh lattice 45" in the embodiment corresponds to an example of the "fifth lattice" in the invention.

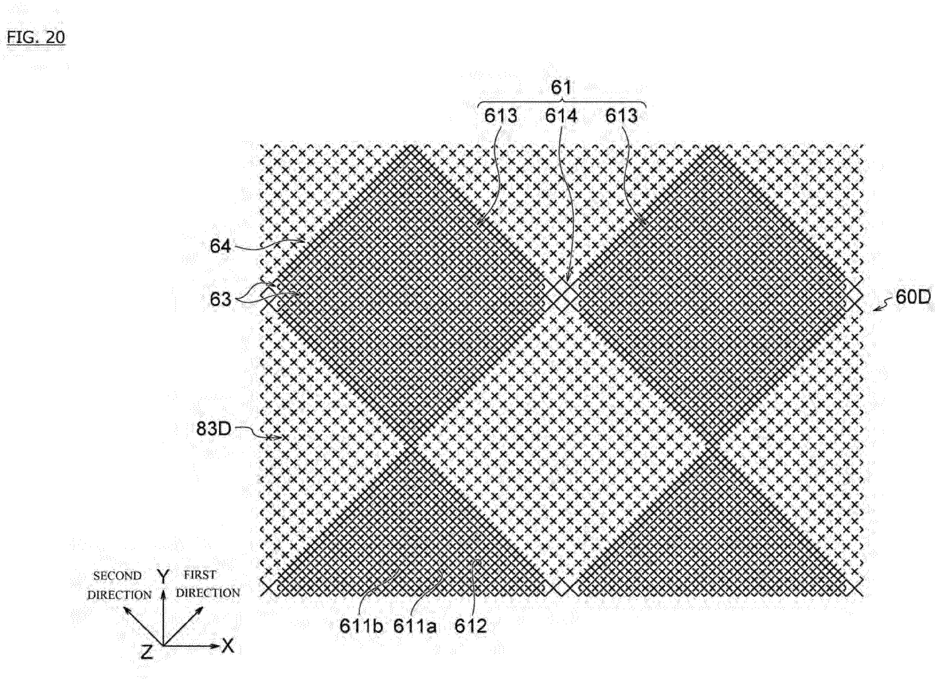

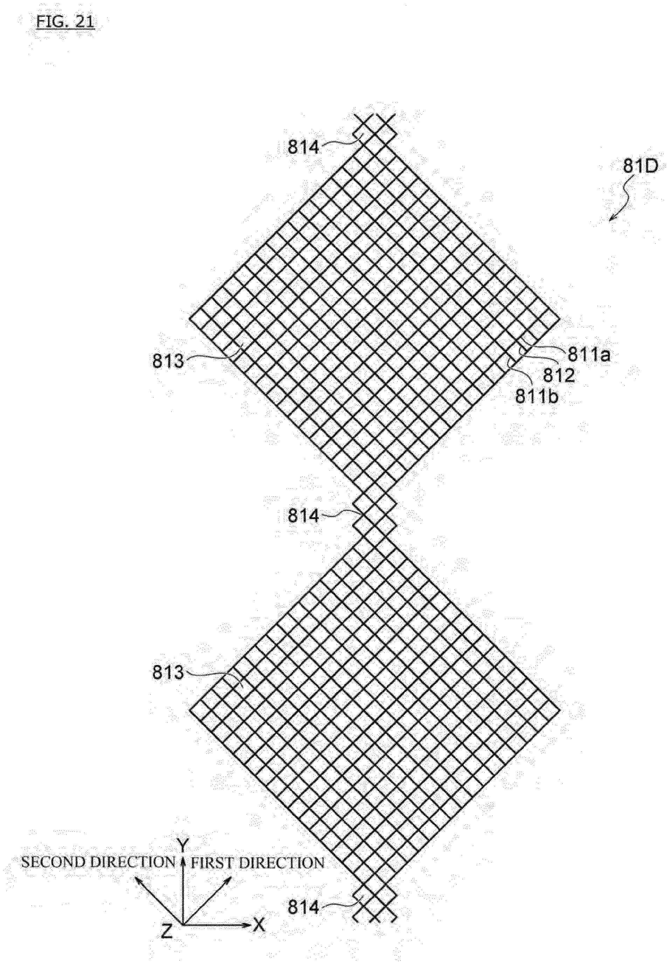

[Third Embodiment] Fig. 20 is a plan view illustrating a first conductor portion according to a third embodiment of the invention, and Fig. 21 is a plan view illustrating a second conductor portion according to the third embodiment of the invention. In the embodiment, the configurations of a first conductor portion 60D and a second conductor portion 80D are different from those of the first embodiment, but other configurations are similar to those of the first embodiment. Hereinafter, only the differences between the first conductor portion 60D according to the third embodiment and that of the first embodiment will be described, the same components as those of the first embodiment are denoted by the same reference numerals, and the description thereof is omitted.

As illustrated in Fig. 20, the first conductor portion 60D further includes a second dummy electrode portion 83D in addition to the first electrode portion 61, the first dummy electrode portion 63, and the third dummy electrode portion 64,. That is, in the third embodiment, the first conductor portion 60D includes all the dummy electrode portions (first to third dummy electrode portions 63, 83D, and 64), and in other words, all the dummy electrode portions are formed on the same plane. Since the first to third dummy electrode portions 63, 83D, and 64 are included in the first conductor portion 60D located closer to the display device than to the second conductor portion 80D, the noise from the display device can be blocked by the first to third dummy electrodes 63, 63D, and 64, the sensor sensitivity is further improved.

Similarly to the dummy electrode 83 in the first embodiment illustrated in Fig. 13, the shape of the second dummy electrode 83D is a cross shape or an L shape, a portion adjacent to the connection portion 614 has an L shape, and other portions have a cross shape. On the other hand, similarly to the other embodiments, a second conductor portion 81D includes the second detection portion 813 and the second connection portion 814, but differently from the other embodiments, as illustrated in Fig. 21, a dummy electrode is not provided inside the second lattice 812 formed by the second thin lines 811a and 811b. As a result, the second dummy electrode 83D provided in the first conductor portion 60D exists inside the second lattice 812 in a see-through plane view.

In the third embodiment, similarly to the first embodiment described above, it is possible to improve the visibility of the wiring body. In the third embodiment, similarly to the above-described first embodiment, since the first to third dummy electrode portions 63, 83D, and 64 are not located between the external conductor F such as a finger and the first and second electrode portions 61 and 81, the sensor sensitivity is improved.

The above-described embodiment is used to facilitate the understanding of the invention and does not limit the invention. Thus, the components disclosed in the above-described embodiment include all modifications in design and equivalents belonging to the technical scope of the invention.

For example, in the above-described embodiment, each thin line included in the first conductor portion 60 and the second conductor portion 80 is formed in a linear shape, but the invention is not limited thereto and for example, a curve, a broken line, a zigzag line, or the like may be used.

In the above-described embodiment, the first dummy electrode portion 63 exists in all the first lattices 612 constituting the first detection portion 613. However, the invention is not limited thereto as long as the first dummy electrode portion 63 exists in at least one first lattice 612 in the non-overlapping region 42. Similarly, in the above-described embodiment, the second dummy electrode portion 83 exists in all the second lattices 812 constituting the second detection portion 813. However, the invention is not limited thereto as long as the second dummy electrode portion 83 exists in at least one second lattice 812 in the non-overlapping region 42.

In the above-described embodiment, the pitch of the first thin line 611 and the pitch of the third thin line 631 are equal to each other, but if the first thin line 611 and the third thin line 631 is not in contact with each other, these pitches may be set to be different from each other. Similarly, the pitch of the second thin line 811 and the pitch of the fourth thin line 831 may be set to be different.

In the above-described embodiment, a pattern (so-called a diamond pattern) including the first detection portion 613 and the first connection portion 614 is used as the electrode pattern of the first electrode portion 61. However, the invention is not particularly thereto, a belt-shaped electrode pattern having a substantially uniform width along the extension direction of the first electrode portion may be used. In addition, for the second electrode portion 81, an electrode pattern corresponding to the electrode pattern adopted in the first electrode portion 61 is used.

In the first electrode portion 61 of the above-described embodiment, the first thin line 611 protruding into the first lattice 612 does not exist, but the invention is not limited thereto, and the first thin line 611 protruding into the first lattice 612 may exist. In this case, since the first thin line 611 protruding into the first lattice 612 and the third thin line 631 of the first dummy electrode portion 63 are located on the same imaginary line in a plane view, the first thin line 611 constituting the first lattice 612, the first thin line 611 protruding into the first lattice 612, and the third thin line 631 are combined to form a fourth lattice 602.

In the first electrode portion 61 of the above-described embodiment, the first thin line 611 protruding from the outline of the first electrode portion 61 does not exist, but the invention is not limited thereto, and the first thin line 611 protruding from the outline of the first electrode portion 61 may exist.

For example, in the embodiment, as the conductive material (conductive particles) constituting the first and second conductor portions 60 and 80, a metal material or a carbon-based material is used. However, the present invention is not particularly limited thereto, and a mixture of a metal material and a carbon material may be used. In this case, for example, if the first thin line 611 is described as an example, the carbon-based material may be disposed on the relatively coarse side of the first thin line 611, and the metal material may be disposed on a relatively flat side. Reversely, the metal material may be disposed on the relatively coarse side of the first thin line 611, and the carbon-based material may be disposed on the relatively flat side.

For example, in a case where a wiring body is configured as a mode in which the lower surface of the first resin portion 50 is adhered to a mounting object (a film, a surface glass, a polarizing plate, a display glass, or the like) to support the wiring body 40 by the mounting object, a release sheet may be provided on the lower surface of the first resin portion 50, and the release sheet may be peeled off at the time of mounting, the wiring body is adhered to the mounting object. The first wiring body may be configured as a mode where a resin portion covering the wiring body 40 is further provided from the first resin portion 50 side, and the first wiring body is adhered to the above-described mounting object via the resin portion. The first wiring body may be configured as a mode where the third resin portion 90 side is adhered to the above-described mounting object. In these cases, the mounting object on which the wiring body is mounted corresponds to an example of the "supporting body" in the invention.

Furthermore, in the above-described embodiment, the wiring body or the wiring board has been described as being used for a touch sensor, but it is not particularly limited thereto. For example, the wiring body may be used as a heater by applying electricity to the wiring body to generate heat by resistance heating or the like. In this case, it is preferable to use a carbon-based material having a relatively high electric resistance value as the conductive particles. The wiring body may be used as an electromagnetic shielding body by grounding a portion of the conductor portion of the wiring body. The wiring body may be used as an antenna. In this case, the mounting object on which the wiring body is mounted corresponds to an example of the "supporting body" of the invention.

EXPLANATIONS OF LETTERS OR NUMERALS

| | |
|---|---|
| 10 | TOUCH SENSOR |
| 20 | WIRING BOARD |
| 30 | SUPPORTING BODY |
| 40 | WIRING BODY |
| 41 | OVERLAPPING REGION |
| 42 | NON-OVERLAPPING REGION |
| 43 | GAP REGION |
| 44 | THIRD LATTICE |
| 45 | SEVENTH LATTICE |
| 50 | FIRST RESIN PORTION |
| 60 | FIRST CONDUCTOR PORTION |
| 601 | INTERSECTION |
| 602 | FOURTH LATTICE |

| | |
|---|---|
| 61 | FIRST ELECTRODE PORTION |
| 611 | FIRST THIN LINE |
| 612 | FIRST LATTICE |
| 613 | FIRST DETECTION PORTION |
| 614 | FIRST CONNECTION PORTION |
| 62 | FIRST LEAD WIRING |
| 63 | FIRST DUMMY ELECTRODE PORTION |
| 631 | THIRD THIN LINE |
| 6311 | END SURFACE |
| 632 | INTERSECTION |
| 633 | FIRST DISCONNECTION PORTION |
| 634 | SECOND DISCONNECTION PORTION |
| 64 | THIRD DUMMY ELECTRODE PORTION |
| 641 | FIFTH THIN LINE |
| 642 | FIFTH LATTICE |
| 70 | SECOND RESIN PORTION |
| 71 | OPENING |
| 80 | SECOND CONDUCTOR PORTION |
| 801 | INTERSECTION |
| 802 | SIXTH LATTICE |
| 81 | SECOND ELECTRODE PORTION |
| 811 | SECOND THIN LINE |
| 812 | SECOND LATTICE |
| 813 | SECOND DETECTION PORTION |
| 814 | SECOND CONNECTION PORTION |
| 82 | SECOND LEAD WIRING |
| 83 | SECOND DUMMY ELECTRODE PORTION |
| 831 | FOURTH THIN LINE |
| 832 | INTERSECTION |
| 833 | THIRD DISCONNECTION PORTION |
| 834 | FOURTH DISCONNECTION PORTION |
| 84 | FOURTH DUMMY ELECTRODE PORTION |
| 841 | SIXTH THIN LINE |
| 90 | THIRD RESIN PORTION |
| 91 | OPENING |
| F | EXTERNAL CONDUCTOR |

**Claims**

1.  A wiring body comprising:

    an insulating portion;
    a first conductor portion provided on one side of the insulating portion and including a first electrode portion; and
    a second conductor portion provided on the other side of the insulating portion and including a second electrode portion, wherein
    the first electrode portion has first thin lines intersecting each other and includes at least one first lattice formed by the first thin lines,
    the second electrode portion has second thin lines intersecting each other and includes at least one second lattice formed by the second thin lines,
    the first electrode portion and the second electrode portion are disposed to face each other, so that, in a see-through plane view, there exist an overlapping region in which the first electrode portion and the second electrode portion partially overlap and a non-overlapping region other than the overlapping region,

in a see-through plane view, an area occupied by the first thin lines and the second thin lines per unit area in the overlapping region of the first electrode portion or the second electrode portion is larger than an area occupied by the first thin lines or the second thin lines per unit area in the non-overlapping region,

the first conductor portion includes a first dummy electrode portion located on the same plane as the first electrode portion and electrically insulated from the first electrode portion, and

the first dummy electrode portion exists in at least one of the first lattices in the non-overlapping region.

2.  The wiring body according to claim 1, wherein the first conductor portion or the second conductor portion includes a second dummy electrode portion located on the same plane as the first electrode portion or the second electrode portion and electrically insulated from the first electrode portion or the second electrode portion, and

in a see-through plane view, the second dummy electrode portion exists in at least one of the second lattices in the non-overlapping region.

3.  The wiring body according to claim 1 or 2, wherein the first dummy electrode portion has third thin lines extending in directions intersecting each other,

third lattices are formed by overlapping the first thin line and the second thin line in the overlapping region,

fourth lattices are formed by combining the first thin line and the third thin line in the non-overlapping region, and

the fourth lattice has substantially the same shape as the third lattice.

4.  The wiring body according to claim 3, wherein the first dummy electrode portion includes at least one first disconnection portion formed at an intersection of the third thin lines.

5.  The wiring body according to claim 3 or 4, wherein in the first electrode portion, the first thin line protruding into the first lattice does not exist, and

the first dummy electrode portion includes second disconnection portions formed at all intersections of the first thin lines and the third thin lines.

6.  The wiring body according to claim 5, wherein the following formula (1) is satisfied,

$$S_1 \leq L/10 \ldots (1)$$

herein, in the formula (1), $S_1$ is an interval between the first thin line and the third thin line at the second disconnection portion, and L is a length of one side of the fourth lattice.

7.  The wiring body according to claim 6, wherein the following formulas (2) and (3) are satisfied,

$$(S_2 - S_3) \times 0.5/H \leq 1 \ldots (2)$$

$$S_3 < 50 \ \mu m \ldots (3)$$

herein, in the formulas (2) and (3), $S_2$ is a maximum interval between the first thin line and the third thin line at the second disconnection portion, $S_3$ is a minimum interval between the first thin line and the third thin line at the second disconnection portion, and H is a height of the third thin line.

8.  The wiring body according to any one of claims 1 to 7, wherein

the non-overlapping region includes a gap region not overlapping both the first electrode portion and the second electrode portion in a see-through plane view,

at least one of the first conductor portion and the second conductor portion includes a third dummy electrode portion located on the same plane as the first electrode portion or the second electrode portion and electrically insulated from the first electrode portion or the second electrode portion, and

the third dummy electrode portion exists in the gap region.

9.  The wiring body according to claim 8, wherein the third dummy electrode portion has fifth thin lines extending in directions intersecting each other and includes at least one fifth lattice formed by the fifth thin line, and

the fifth lattice has substantially the same shape as the third lattice.

10. The wiring body according to any one of claims 1 to 9, wherein

the first electrode portion includes:

first detection portions having a substantially rhombus shape in a plane view and juxtaposed in an extension direction of the first electrode portion; and

a first connection portion connecting the adjacent first detection portions to each other,

the second electrode portion includes:

second detection portions having a substantially rhombus shape in a plane view and juxtaposed in an extension direction of the second electrode portion; and
a second connection portion connecting the adjacent second detection portions with each other,

the first connection portion and the second connection portion are disposed in the overlapping region, and
the first detection portion and the second detection portion are disposed in the non-overlapping region.

**11.** A wiring board comprising:

the wiring body according to any one of claims 1 to 10; and
a supporting body supporting the wiring body.

**12.** A touch sensor detecting a touch position of an external conductor, comprising the wiring board according to claim 11, wherein
the second conductor portion is disposed so as to be interposed between the external conductor and the first conductor portion.

FIG. 1

FIG. 2

FIG. 3

EP 3 564 800 A1

FIG. 4

61

613

613

614

614

614

V

V

611b

611a

612

Y

SECOND DIRECTION   FIRST DIRECTION

Z ——→ X

FIG. 5

FIG. 6

814

81

813

811a
812
811b

814

813

814

SECOND DIRECTION ← Y → FIRST DIRECTION

Z → X

FIG. 7

FIG. 8

FIG. 9

EP 3 564 800 A1

FIG. 10

FIG. 11

EP 3 564 800 A1

FIG. 12

83

81 { 813
      814
      813

XIII

83

Y

SECOND DIRECTION ↑ FIRST DIRECTION

Z ——→ X

FIG. 13

FIG. 14

EP 3 564 800 A1

SECOND DIRECTION ← → FIRST DIRECTION

EP 3 564 800 A1

FIG. 15

EP 3 564 800 A1

FIG. 16

FIG. 17

EP 3 564 800 A1

FIG. 18

SECOND DIRECTION ← Y → FIRST DIRECTION

Z → X

FIG. 19

EP 3 564 800 A1

FIG. 20

FIG. 21

814

81D

813

811a
812
811b

814

813

814

SECOND DIRECTION  FIRST DIRECTION

Y

Z    X

# EP 3 564 800 A1

<table>
<tr><td colspan="2"><b>INTERNATIONAL SEARCH REPORT</b></td><td>International application No.<br>PCT/JP2017/046438</td></tr>
</table>

**A. CLASSIFICATION OF SUBJECT MATTER**

Int.Cl. G06F3/041(2006.01)i, G06F3/044(2006.01)i, H05K1/02(2006.01)i

According to International Patent Classification (IPC) or to both national classification and IPC

**B. FIELDS SEARCHED**

Minimum documentation searched (classification system followed by classification symbols)

Int.Cl. G06F3/041, G06F3/044, H05K1/02

| Documentation searched other than minimum documentation to the extent that such documents are included in the fields searched | |
|---|---|
| Published examined utility model applications of Japan | 1922–1996 |
| Published unexamined utility model applications of Japan | 1971–2018 |
| Registered utility model specifications of Japan | 1996–2018 |
| Published registered utility model applications of Japan | 1994–2018 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y<br>A | JP 2014-219986 A (SAMSUNG ELECTRO-MECHANICS CO., LTD.) 20 November 2014, paragraphs [0042], [0048], [0057]-[0062], [0067], fig. 1-4, 7-8 & US 2014/0333555 A1, paragraphs [0052], [0057], [0066]-[0071], [0076], fig. 1-4, 7-8 | 1-2, 11-12<br>8-10<br>3-7 |
| X<br>Y<br>A | JP 2016-38753 A (TOPPAN PRINTING CO., LTD.) 22 March 2016, paragraphs [0034]-[0043], [0104]-[0123], fig. 1-3, 6, 8, 10 (Family: none) | 1-2, 11-12<br>8-10<br>3-7 |
| Y<br>A | WO 2016/002583 A1 (JAPAN AVIATION ELECTRONICS INDUSTRY LTD.) 07 January 2016, paragraphs [0016], [0023]-[0027], fig. 10-12 & JP 2016-15013 A & US 2017/0108964 A1, paragraphs [0042], [0049]-[0054], fig. 10-12 | 8-10<br>3-7 |

☒ Further documents are listed in the continuation of Box C.  ☐ See patent family annex.

| * Special categories of cited documents: | |
|---|---|
| "A" document defining the general state of the art which is not considered to be of particular relevance | "T" later document published after the international filing date or priority date and not in conflict with the application but cited to understand the principle or theory underlying the invention |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>27 February 2018 (27.02.2018) | Date of mailing of the international search report<br>13 March 2018 (13.03.2018) |
|---|---|
| Name and mailing address of the ISA/<br>Japan Patent Office<br>3-4-3, Kasumigaseki, Chiyoda-ku,<br>Tokyo 100-8915, Japan | Authorized officer<br><br>Telephone No. |

Form PCT/ISA/210 (second sheet) (January 2015)

**INTERNATIONAL SEARCH REPORT**

| International application No. |
|---|
| PCT/JP2017/046438 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2015-108884 A (FUJIFILM CORP.) 11 June 2015, paragraphs [0073]-[0079], fig. 12 & US 2016/0274703 A1, paragraphs [0092]-[0098], fig. 12 & WO 2015/083419 A1 | 1-12 |
| A | WO 2014/119231 A1 (SHARP CORP.) 07 August 2014, paragraphs [0083]-[0084], fig. 7 & US 2015/0370375 A1, paragraphs [0108]-[0109], fig. 7 & CN 104956296 A | 6-7 |
| A | JP 2016-540304 A (LG CHEM LTD.) 22 December 2016, paragraph [0053], fig. 26 & US 2016/0364043 A1, paragraph [0080], fig. 26 & WO 2015/088295 A1 & EP 3082023 A1 | 6-7 |
| A | WO 2015/156316 A1 (FUJIKURA LTD.) 15 October 2015, paragraphs [0055]-[0072], fig. 6 & US 2017/0102804 A1, paragraphs [0069]-[0086], fig. 6 & EP 3130992 A1 | 6-7 |

Form PCT/ISA/210 (continuation of second sheet) (January 2015)

**REFERENCES CITED IN THE DESCRIPTION**

**Patent documents cited in the description**

- JP 2016256468 A
- JP 4820451 B
- JP 5615856 B